# EUROPEAN PATENT APPLICATION

(11) **EP 1 947 683 A1**
(43) Date of publication of application: **23.07.2008**
(21) Application number: 06823173.7
(22) Date of filing: 08.11.2006
(51) Int. Cl.: H01L 21/027, G03F 7/20

(54) **EXPOSURE APPARATUS, EXPOSURE METHOD AND DEVICE MANUFACTURING METHOD**

(30) Priority: 09.11.2005 JP 2005324619
(71) Applicant: Nikon Corporation, Tokyo 100-8331 (JP)
(72) Inventor: NAGASAKA, Hiroyuki c/o NIKON CORPORATION, I.P.D.,, Chiyoda-ku, Tokyo 1008331 (JP)
(74) Representative: Viering, Jentschura & Partner
(86) International application number: PCT/JP2006/322269
(87) International publication number: WO 2007/055237

(57) **Abstract**

An exposure apparatus (EX) performs a multiple exposure of a substrate (P) and comprises: a first station (ST1) that exposes the substrate (P); a second station (ST2) that exposes the substrate (P) that was exposed at the first station (ST1); movable members (4, 5) each of that holds the substrate (P) and is capable of moving between the first station (ST1) and the second station (ST2); and a first detection system (9) that is disposed in the first station (ST1) and acquires alignment information about the substrate (P).

## Description

### TECHNICAL FIELD

The present invention relates to an exposure apparatus and an exposing method that expose a substrate, and to a device fabricating method.

Priority is claimed on Japanese Patent Application No. 2005-324619, filed on November 9,2005, the contents of which are incorporated herein by reference.

### BACKGROUND ART

Among exposure apparatuses that are used in photolithography, an exposure apparatus is known that performs multiple exposures on substrates, as disclosed in, for example, Patent Document 1 mentioned below.

Patent Document 1: Japanese Patent Application, Publication No. H10-214783A

### DISCLOSURE OF INVENTION

### PROBLEMS TO BE SOLVED BY THE INVENTION

In a case wherein an exposure apparatus performs a multiple exposure that requires steps such as exchanging masks and modifying illumination conditions and the like with each exposure, there is a possibility that the operating ratio of the exposure apparatus will decrease if such steps take a long time, thereby reducing throughput.

A purpose of the present invention is to provide: an exposure apparatus and an exposing method that can prevent throughput from decreasing by efficiently performing a multiple exposure on a substrate; as well as a device fabricating method.

### MEANS FOR SOLVING THE PROBLEM

The present invention adopts the following configurations that correspond to the drawings, which describe the embodiments. However, any parenthesized symbol appended to an element is merely for the purpose of illustration and that element is not limited thereby.

A first aspect of the invention provides an exposure apparatus (EX) for performing a multiple exposure that comprises: a first station (ST1); a second station (ST2); a first movable member (4) that holds a substrate (P) and that is capable of moving between the first station (ST1) and the second station (ST2); a second movable member (5) that holds a substrate (P) and that is capable of moving between the first station (ST1) and the second station (ST2); and a first detection system (9) that is disposed in the first station (ST1); wherein, alignment information about the substrate (P) that is held by the first movable member (4) is acquired using the first detection system (9) in the first station (ST1); the substrate (P) that is held by the first movable member (4) is exposed in the first station (ST1) based on the alignment information; the substrate (P) that is held by the second movable member (5) is exposed in the second station (ST2) in parallel with at least part of the exposure of the substrate (P) that is held by the first movable member (4) in the first station (ST1); the first movable member (4) is moved from the first station (ST1) to the second station (ST2) after the exposure of the substrate (P) that is held by the first movable member (4) at the first station (ST1) and the exposure of the substrate (P) that is held by the second movable member (5) at the second station (ST2) are complete; and the substrate (P) that is held by the first movable member (4) is exposed at the second station (ST2) based on the alignment information.

According to the first aspect of the invention, it is possible to perform a multiple exposure on the substrates efficiently.

A second aspect of the invention provides a device fabricating method wherein an exposure apparatus (EX) according to the abovementioned aspect is used.

According to the second aspect of the invention, it is possible to fabricate a device by using the exposure apparatus that can efficiently perform a multiple exposure on a substrate.

A third aspect of the invention provides an exposing method for performing a multiple exposure that comprises the steps of: acquiring alignment information about a substrate (P) that is held by a first movable member (4) in a first station (ST1); exposing the substrate (P) that is held by the first movable member (4) in the first station (ST1) based on the alignment information; exposing a substrate (P) that is held by a second movable member (5) in a second station (ST2) in parallel with at least part of the exposure of the substrate (P) that is held by the first movable member (4) in the first station (ST1); moving the first movable member (4) from the first station (ST1) to the second station (ST2) after the exposure of the substrate (P) that is held by the first movable member (4) at the first station (ST1) and the exposure of the substrate (P) that is held by the second movable member (5) at the second station (ST2) are complete; and exposing the substrate (P) that is held by the first movable member (4) at the second station (ST2) based on the alignment information.

According to the third aspect of the invention, it is possible to perform a multiple exposure on the substrates efficiently.

A fourth aspect of the invention provides a device fabricating method wherein an exposing method according to the abovementioned aspects of the invention is used.

According to the fourth aspect of the invention, it is possible to fabricate a device by using the exposing method that can efficiently perform a multiple exposure on a substrate.

### EFFECTS OF THE INVENTION

The present invention can efficiently perform a multiple exposure on a substrate while preventing throughput from decreasing, thereby improving device productivity.

### BRIEF DESCRIPTION OF THE DRAWINGS

FIG. 1 is a schematic block diagram that shows one embodiment of the exposure apparatus.
FIG. 2 is a plan view of a first substrate stage and a second substrate stage, viewed from above.
FIG. 3 shows part of a laser interferometer system.
FIG. 4 is a view for explaining an immersion system.
FIG. 5 is a view for explaining an operation that exposes a substrate at a first station.
FIG. 6 is a view for explaining an operation that exposes the substrate at a second station.
FIG. 7 is a flow chart for explaining the basic operation of the exposure apparatus.
FIG. 8 is a flow chart for explaining the basic operation of the exposure apparatus.
FIG. 9 is a plan view for explaining the operation of a substrate stage.
FIG. 10 is a plan view for explaining the operation of the substrate stage.
FIG. 11 is a plan view for explaining the operation of the substrate stage.
FIG. 12 is a plan view for explaining the operation of the substrate stage.
FIG. 13 is a plan view for explaining the operation of the substrate stage.
FIG. 14 is a plan view for explaining the operation of the substrate stage.
FIG. 15 is a side view for explaining the operation of the substrate stage.
FIG. 16 is a schematic drawing for explaining the action of the exposure apparatus according to the present embodiment.
FIG. 17 is a flow chart diagram for explaining one example of a process of fabricating a microdevice.

### DESCRIPTION OF THE REFERENCE SYMBOLS

- 1: Immersion system
- 2: Interferometer system
- 4: First substrate stage
- 5: Second substrate stage
- 8: Focus and level detection system
- 9: Mark detection system
- 10: Control apparatus
- AM: Alignment mark
- EL: Exposure light
- EX: Exposure apparatus
- FL1: Last optical element
- FL2: Last optical element
- H: Transport system
- LQ: Liquid
- LR: Liquid immersion region
- P: Substrate
- PD: Substrate stage drive apparatus
- PL1: First projection system
- PL2: Second projection system
- SP1: First area
- SP2: Second area
- ST1: First station
- ST2: Second station

### BEST MODE FOR CARRYING OUT THE INVENTION

The following explains the embodiments of the present invention referencing the drawings, but the present invention is not limited thereto. Furthermore, the following explanation defines an XYZ orthogonal coordinate system, and the positional relationships among members are explained referencing this system. Furthermore, prescribed directions within the horizontal plane are the X axial directions, directions that are orthogonal to the X axial directions in the horizontal plane are the Y axial directions, and directions that are orthogonal to the X axial directions and the Y axial directions (i.e., the vertical directions) are the Z axial directions. In addition, the rotational (the inclined) directions around the X, Y, and Z axes are the θX, θY, and θZ directions, respectively.

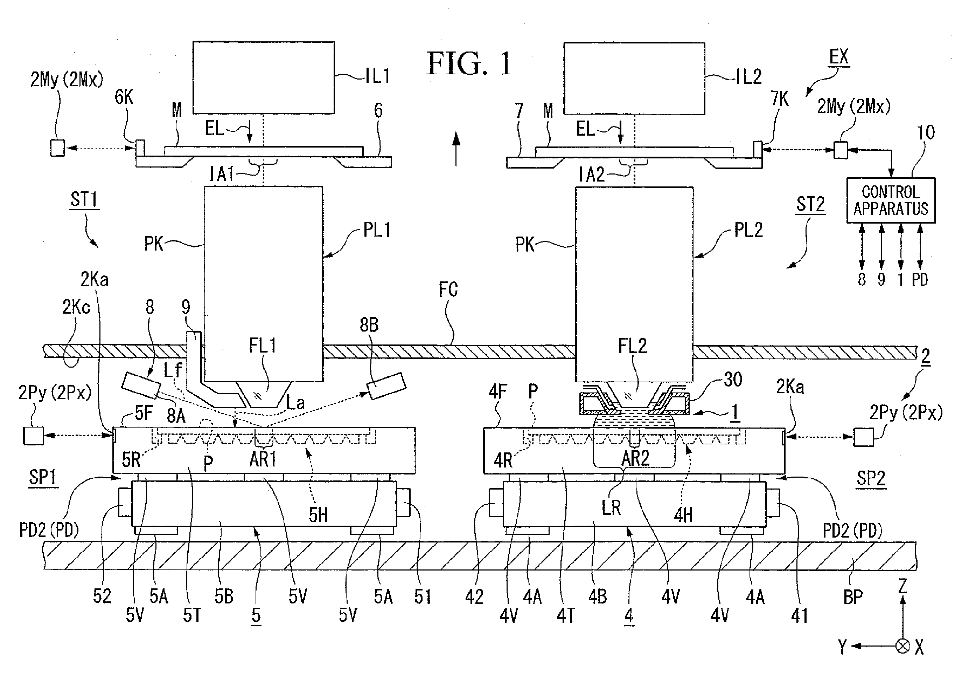

FIG. 1 is a schematic block diagram that shows the exposure apparatus EX according to the present embodiment. The exposure apparatus EX of the present embodiment is an exposure apparatus that performs multiple exposures on a substrate P, and comprises: a first station ST1 that exposes the substrate P; a second station ST2 that exposes the substrate P that was exposed by the first station ST1; a first substrate stage 4 that holds the substrate P and is movable within prescribed areas that include: a first area SP1 at which the substrate P can be irradiated with an exposure light EL in the first station ST1; and a second area SP2 at which the substrate P can be irradiated with another exposure light EL in the second station ST2; a second substrate stage 5, which holds the substrate P independently of the first substrate stage 4 and is movable within the prescribed areas that include the first area SP 1 and the second area SP2; a mark detection system 9 that is disposed in the first station ST1 and acquires alignment information about the substrate P; a focus and level detection system 8 that is disposed in the first station ST1 and acquires surface information about the front surface of the substrate P; and a control apparatus 10 that controls the operation of the entire exposure apparatus EX. FIG. 1 shows a state wherein the first substrate stage 4 is disposed in the second area SP2 of the second station ST2 and the second substrate stage 5 is disposed in the first area SP1 of the first station ST1.

The first station ST1 comprises: a movable first mask stage 6 that holds a mask M; a first illumination system IL1 that illuminates the mask M that is held by the first mask stage 6 with the corresponding exposure light EL; and a first projection system PL1 that projects an image of a pattern of the mask M, which is illuminated by the exposure light EL, onto the substrate P. The second station ST2 comprises: a movable second mask stage 7 that holds another mask M; a second illumination system IL2 that illuminates the mask M that is held by the second mask stage 7 with the corresponding exposure light EL; and a second projection system PL2 that projects the image of the pattern of the mask M that is illuminated with that exposure light EL onto the substrate P. The first station ST1 and the second station ST2 are provided so that they are spaced apart. In addition, the exposure apparatus EX comprises a laser interferometer system 2 that measures positional information of each of these stages.

Furthermore, the substrate described herein includes one wherein a photosensitive material (photoresist) and a film of, for example, a protective film are coated on a base material such as a semiconductor wafer. The mask includes a reticle, wherein a device pattern is formed that is reduction projected onto the substrate. In addition, a transmitting type mask is used as the mask in the present embodiment, but a reflection type mask may also be used.

In addition, in the present embodiment, a dry exposure is performed at the first station ST1, wherein the corresponding exposure light EL is radiated on the substrate P without going through a liquid LQ, and an immersion exposure is performed at the second station ST2, wherein the exposure light EL is radiated on the substrate P through the liquid LQ. At least part of an immersion system 1, which fills an optical path space of the exposure light EL in the vicinity of the image plane of the second projection system PL2 with the liquid LQ, is provided to the second station ST2. In the present embodiment, water (pure water) is used as the liquid LQ.

The first and second illumination systems IL1, IL2 use the exposure lights EL, each of which has a uniform luminous flux intensity distribution, to illuminate prescribed illumination areas IA1, IA2, respectively, on the masks M that are held by the first and second mask stages 6, 7. Examples of light that can be used as the exposure lights EL emitted from the first and second illumination systems IL1, IL2 include: deep ultraviolet light (DUV light) such as bright line (g-line, h-line, or i-line) light emitted from, for example, a mercury lamp, and KrF excimer laser light (248 nm wavelength); and vacuum ultraviolet light (VUV light) such as ArF excimer laser light (193 nm wavelength) and F₂ laser light (157 nm wavelength). ArF excimer laser light is used in the present embodiment.

Each of the first and second mask stages 6, 7, in the state wherein it holds the corresponding mask M, is movable in the X axial, Y axial, and θZ directions by a mask stage drive apparatus that comprises an actuator, e.g., a linear motor. The laser interferometer system 2 measures the positional information of the first and second mask stages 6, 7 (and thus the masks M). The laser interferometer system 2 comprises laser interferometers 2Mx, 2My that measure the positional information of the first and second mask stages 6, 7 using reflecting mirrors 6K, 7K, which are provided on the first and second mask stages 6, 7. The laser interferometers 2Mx are capable of irradiating the reflecting mirrors 6K, 7K with measurement lights, the measurement axes of which are set in the X axial directions, and measure the positions of the first and second mask stages 6, 7 in the X axial directions. The laser interferometers 2My are capable of irradiating the reflecting mirrors 6K, 7K with measurement lights, the measurement axes of which are set in the Y axial directions, and measure the positions of the first and second mask stages 6, 7 in the Y axial directions. In addition, providing a plurality of at least one of the laser interferometers 2Mx and the laser interferometers 2My and radiating a plurality of at least one of the measurement lights that have measurement axes set in the X axial directions and the measurement lights that have measurement axes set in the Y axial directions enable the laser interferometer system 2 to measure the positional information of the first and second mask stages 6, 7 in the θZ directions using that plurality of measurement lights. Based on the measurement results of the laser interferometer system 2, the control apparatus 10 controls the position of the masks M, which are held by the first and second mask stages 6, 7, by controlling the mask stage drive apparatus.

Furthermore, each of the reflecting mirrors need not simply be a plane mirror, but may include a corner cube (retroreflector); furthermore, it is acceptable to use, for example, a reflecting surface that is formed by mirror polishing an end surface (side surface) of the corresponding mask stage, instead of providing the reflecting mirror so that it is fixed to that mask stage. In addition, each of the mask stages may be constituted so that it is coarsely and finely movable, as disclosed in, for example, Japanese Patent Application, Publication No. H8-130179A (corresponding U.S. Patent No. 6,721,034).

Each of the first and second projection optical systems PL1, PL2 projects an image of the pattern of the corresponding mask M on the substrate P at a prescribed projection magnification, and comprises a plurality of optical elements, which are held by a lens barrel PK. Each of the first and second projection optical systems PL1, PL2 of the present embodiment is a reduction system with a projection magnification of, for example, 1/4, 1/5, or 1/8, and forms a reduced image of the pattern of the corresponding mask in a corresponding projection area, which is optically conjugate with the corresponding illumination area discussed above. Furthermore, the first and second projection optical systems PL1, PL2 may be reduction systems, unity magnification systems, or enlargement systems. In addition, the first and second projection optical systems PL1, PL2 may be: dioptric systems that do not include catoptric elements; catoptric systems that do not include dioptric elements; or catadioptric systems that include both catoptric elements and dioptric elements. In addition, the projection optical systems PL1, PL2 may form either inverted images or erect images.

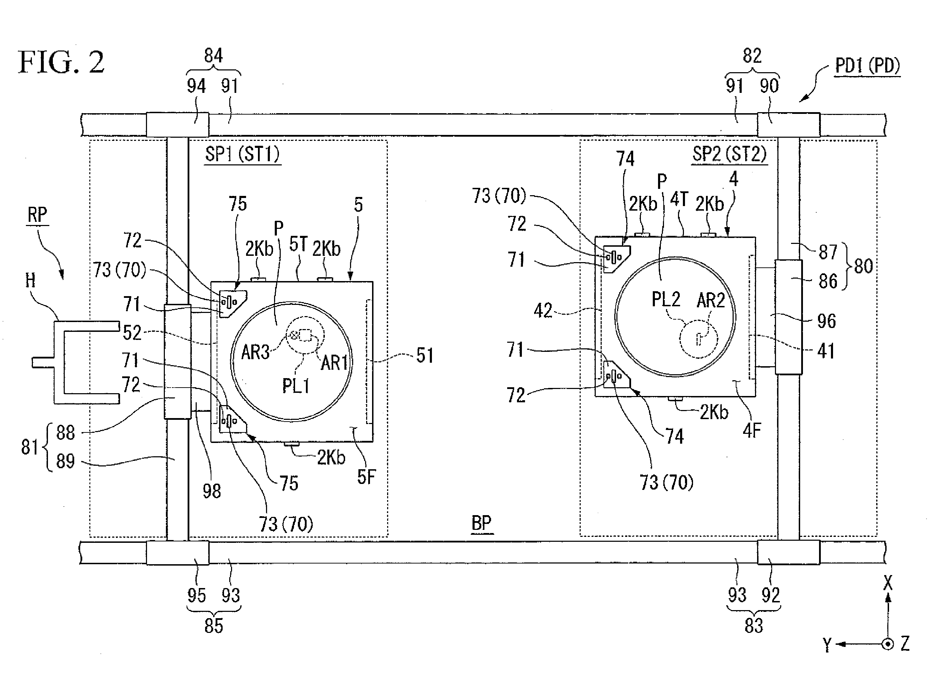

The following explains the movable substrate stages 4, 5, each of which holds the substrate P, referencing FIG. 1 and FIG. 2. FIG. 2 is a plan view of the substrate stages 4, 5, viewed from above.

In FIG. 1 and FIG. 2, the first substrate stage 4 comprises: a stage main body 4B; a first substrate table 4T, which is mounted on the stage main body 4B; and a substrate holder 4H, which is provided to the first substrate table 4T and holds the substrate P. The substrate holder 4H is disposed in a recessed part 4R, which is provided on the first substrate table 4T, and an upper surface 4F around the recessed part 4R of the first substrate table 4T is a flat surface, the height of which is substantially the same as (flush with) the front surface of the substrate P that is held by the substrate holder 4H. Furthermore, there may be a level difference between the front surface of the substrate P that is held by the substrate holder 4H and the upper surface 4F of the first substrate table 4T.

The second substrate stage 5 has a configuration that is equivalent to that of the first substrate stage 4 and comprises: a stage main body 5B; a second substrate table 5T, which is mounted on the stage main body 5B; and a substrate holder 5H, which is provided to the second substrate table 5T and holds the substrate P. The substrate holder 5H is disposed in a recessed part 5R, which is provided on the second substrate table 5T, and an upper surface 5F around the recessed part 5R of the second substrate table 5T is a flat surface, the height of which is substantially the same as (flush with) the front surface of the substrate P that is held by the substrate holder 5H. Furthermore, there may be a level difference between the front surface of the substrate P that is held by the substrate holder 5H and the upper surface 5F of the second substrate table 5T.

Furthermore, part of the upper surfaces 4F, 5F of the substrate tables 4T, 5T, e.g., just the prescribed areas that surround the substrate P, may be at substantially the same height as the front surface of the substrate P. In addition, with the present embodiment, the substrate holders 4H, 5H and the substrate tables 4T, 5T are configured separately; for example, the substrate holders 4H, 5H are fixed to the recessed parts of the substrate table 4T, 5T by, for example, vacuum chucking, but they may be formed integrally with the substrate tables 4T, 5T.

The exposure apparatus EX comprises a substrate stage drive apparatus PD, which drives the first and second substrate stages 4, 5. The substrate stage drive apparatus PD comprises: a first drive system PD1 that is capable of moving the substrate tables 4T, 5T that are mounted on the stage main bodies 4B, 5B, respectively, in the X axial directions, the Y axial directions, and the θZ directions by moving the stage main bodies 4B, 5B in the X axial directions, the Y axial directions, and the θZ directions on the base member BP; and second drive systems PD2, which are capable of moving the substrate tables 4T, 5T in the Z axial directions, the θX directions, and the θY directions with respect to the stage main bodies 4B, 5B.

As shown in FIG. 1, each of the stage main bodies 4B, 5B of the first and second substrate stages 4, 5 are noncontactually supported by an upper surface (a guide surface) of the base member BP via air bearings 4A, 5A. The upper surface of the base member BP is substantially parallel to the XY plane, and the first substrate stage 4 and the second substrate stage 5 are capable of moving independently on the base member BP within the XY plane.

The first drive system PD1 of the substrate stage drive apparatus PD includes actuators, such as linear motors, and can move the stage main bodies 4B, 5B, which are noncontactually supported on the base member BP, in the X axial directions, the Y axial directions, and the θZ directions. In FIG. 2, the first drive system PD1 comprises linear motors 80, 81, 82, 83, 84, 85. The first drive mechanism PD1 comprises a pair ofY axis linear guides 91, 93, each of which extends in the Y axial directions. Moreover, two sliders 90, 94 are supported on the Y axis linear guide 91 noncontactually so that they are movable in the Y axial directions. Likewise, two sliders 92, 95 are supported on the other Y axis linear guide 93 noncontactually so that they are movable in the Y axial directions. In the present embodiment, at least part of each of the moving coil type Y axis linear motors 82, 84 is formed by the sliders 90, 94, respectively, each of which comprises a coil unit, and the Y axis linear guide 91, which comprises a magnet unit. Likewise, at least part of each of the moving coil type Y axis linear motors 83, 85 is formed by the sliders 92, 95, respectively, and the Y axis linear guide 93.

The sliders 90, 92 of the Y axis linear motors 82, 83 are fixed to one end and the other end (in the longitudinal directions), respectively, of an X axis linear guide 87, which extends in the X axial directions. In addition, the sliders 94, 95 of the Y axis linear motors 84, 85 are fixed to one end and the other end (in the longitudinal directions), respectively, of an X axis linear guide 89, which extends in the X axial directions. Accordingly, the X axis linear guide 87 is movable in the Y axial directions by the Y axis linear motors 82, 83, and the X axis linear guide 89 is movable in the Y axial directions by the Y axis linear motors 84, 85.

In addition, a slider 86 is supported on the X axial linear guide 87 noncontactually so that it is capable of moving in the X axial directions. Similarly, a slider 88 is supported noncontactually on the X axial linear guide 89 so that it is movable in the X axial directions.

In addition, in FIG. 2, the first and second substrate stages 4, 5 is releasably connected to the sliders 86, 88 via joint members 96, 98, respectively, as disclosed in, for example, Published Japanese Translation No. 2000-511704 of the PCT International Publication (corresponding U.S. Patent No. 6,262,796) and Japanese Patent Application Publication No. 2001-223159A (corresponding U.S. Patent No. 6,498,350). The first substrate stage 4 comprises a first joint member 41, which is provided to its side surface on the -Y side of the stage body 4B, and a second joint member 42, which is provided to its side surface on the +Y side. Similarly, the second substrate stage 5 comprises a third joint member 51, which is provided to its side surface on the-Y side of the stage body 5B, and a fourth joint member 52, which is provided to its side surface on the +Y side. The joint member 96 that is provided to the slider 86 is alternately connected to the first and third joint members 41, 51 of the stage main bodies 4B, 5B, and the joint member 98 that is provided to the slider 88 is alternately connected to the second and fourth joint members 42, 52 of the stage main bodies 4B, 5B. Through these joint members, the slider 86 is alternately connected to the first and second substrate stages 4, 5, and the slider 88 is alternately connected to the first and second substrate stages 4, 5.

Furthermore, at least part of the moving magnet type X axis linear motor 80 is formed by the slider 86, which comprises a magnet unit, and the X axis linear guide 87, which comprises a coil unit; furthermore, at least part of the moving magnet type X axis linear motor 81 is formed by the slider 88, which comprises a magnet unit, and the X axis linear guide 89, which comprises a coil unit. The control apparatus 10 can control the positions of the first and second substrate stages 4, 5 in the X axial directions by driving the X axis linear motors 80, 81.

In addition, the control apparatus 10 can control the position of the first substrate stage 4 or the second substrate stage 5 in the Y axial directions when either one is connected to the slider 86 via the joint member 96 by driving the X axis linear guide 87 using the pair of Y axis linear motors 82, 83. Similarly, the control apparatus 10 can control the position of the first substrate stage 4 or the second substrate stage 5 in the Y axial directions when either one is connected to the slider 88 via the joint member 98 by driving the X axis linear guide 89 using the pair of Y axis linear motors 84, 85. In addition, the control apparatus 10 can control the position of the first substrate stage 4 or the second substrate stage 5 in the θZ directions when either one is connected to the slider 86 by creating a slight difference in the amount of drives (thrusts) of the Y axis linear motors 82, 83. Similarly, the control apparatus 10 can control the position of the first substrate stage 4 or the second substrate stage 5 in the θZ directions when either one is connected to the slider 88 by creating a slight difference in the amount of drives (thrusts) of the Y axis linear motors 84, 85.

As shown in FIG. 1, the second drive systems PD2 of the substrate stage drive apparatus PD comprise actuators 4V, 5V, e.g., voice coil motors, that are interposed between the stage main bodies 4B, 5B and the substrate tables 4T, 5T, respectively. As shown in FIG. 1, the substrate table 4T is supported on the stage main body 4B by at least three actuators 4V. Each of the actuators 4V can move the substrate table 4T independently with respect to the stage main body 4B in the Z axial directions. The control apparatus 10 drives the substrate table 4T with respect to the stage main body 4B in the Z axial directions, the θX directions, and the θY directions by adjusting the amount of drive of each of the three actuators 4V. Similarly, the substrate table 5T is supported on the stage main body 5B by at least three actuators 5V, and the control apparatus 10 can move the substrate table 5T with respect to the stage main body 5B in the Z axial directions, the θX directions, and the θY directions by adjusting the amount of drive of each of the three actuators 5V.

Thus, the substrate stage drive apparatus PD, which includes the first and second drive systems PD1, PD2, is capable of moving each of the substrate tables 4T, 5T of the first and second substrate stages 4, 5 with six degrees of freedom, i.e., in the X axial, the Y axial, the Z axial, the θX, the θY, and the θZ directions. By controlling the substrate stage drive apparatus PD, the control apparatus 10 can control the position of the front surface of the substrate P, which is held by the substrate holders 4H, 5H of the substrate tables 4T, 5T, with six degrees of freedom, i.e., in the X axial, the Y axial, the Z axial, the θX, the θY, and the θZ directions.

As shown in FIG. 1 and FIG. 2, the first area SP 1 and the second area SP2 are set on the base member BP. The first area SP1 is set in the first station ST1 and includes an area that opposes the lower surface of a last optical element PL1, which is the optical element of the plurality of optical elements of the first projection system PL1 that is closest to the image plane of the first projection system PL1. The second area SP2 is an area that is different from the first area SP1, is set in the second station ST2, and includes an area that opposes the lower surface of a last optical element FL2, which is the optical element of the plurality of optical elements of the second projection system PL2 that is closest to the image plane of the second projection system PL2. The control apparatus 10 can use the substrate stage drive apparatus PD (first drive system PD1) to move the first substrate stage 4 and the second substrate stage 5 within prescribed areas on the base member BP that include the first area SP1 and the second area SP2. Namely, the first substrate stage 4 and the second substrate stage 5 can each move to and from the first station ST1 and the second station ST2.

As shown in FIG. 2, measurement areas 74, 75, at which exposure related measurements are performed and that are capable of opposing the last optical elements FL1, FL2, respectively, are provided to the substrate tables 4T, 5T of the first and second substrate stages 4, 5, respectively. The measurement areas 74 are provided at prescribed positions on the substrate table 4T of the first substrate stage 4. In the present embodiment, the measurement areas 74 of the substrate table 4T comprise two measurement areas 74A, 74B. In addition, the measurement areas 75 are provided at prescribed positions on the substrate table 5T of the second substrate stage 5. Similar to the substrate table 4T, the measurement areas 75 of the substrate table 5T comprise two measurement areas 75A, 75B. Furthermore, each of the measurement areas 74, 75 on the first and second substrate stages 4, 5 is provided with a fiducial surface 71, a fiducial mark (fiducial mask) 72, and an opening 73, and at least part of a light sensor 70, which is capable of receiving the light that transmits through that opening 73, is provided below the opening 73 (inside the substrate tables 4T, 5T), as disclosed in, for example, Japanese Patent Application Publication No. 2002-158168A (corresponding U.S. Patent No. 6,710,849).

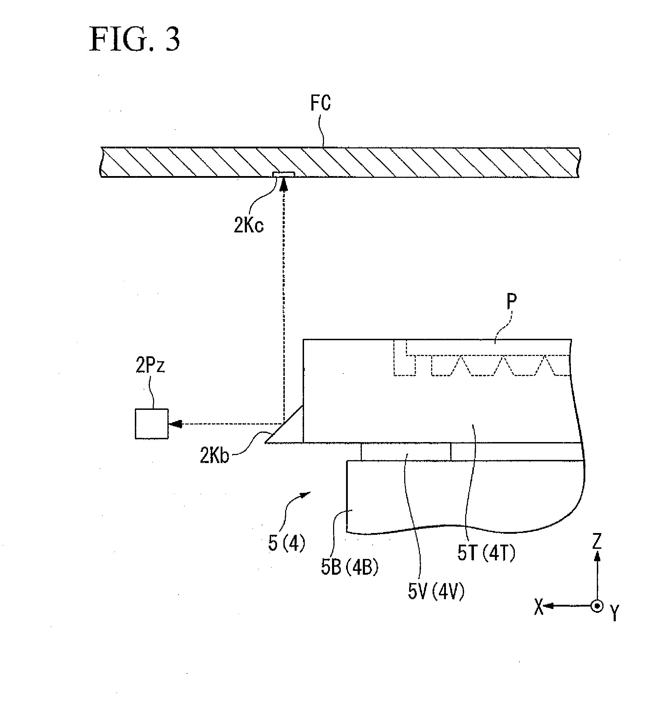

The following explains one example of the laser interferometer system 2 that measures positional information of the first and second substrate stages 4, 5, referencing FIG. 1 and FIG 3. The laser interferometer system 2 can measure positional information of the substrate tables 4T, 5T with six degrees of freedom, i.e., in the X axial, the Y axial, the Z axial, the θX, the θY, and the θZ directions, using reflecting surfaces 2Ka, 2Kb, which are provided at prescribed positions of the substrate tables 4T, 5T of the first and second substrate stages 4, 5.

The laser interferometer system 2 comprises laser interferometers 2Px, 2Py, 2Pz that measure positional information of the first and second substrate stages 4, 5 (the substrate tables 4T, 5T) using the reflecting surfaces 2Ka, 2Kb that are provided at prescribed positions of the substrate tables 4T, 5T of the first and second substrate stages 4, 5. The laser interferometers 2Px, 2Py, 2Pz are provided to the first station ST1 as well as to the second station ST2; furthermore, the laser interferometers 2Px, 2Py, 2Pz that are provided to the first station ST1 measure the positional information of the first substrate stage 4 (or the second substrate stage 5) when it is present at the first station ST1, and the laser interferometers 2Px, 2Py, 2Pz that are provided to the second station ST2 measure the positional information of the second substrate stage 5 (or the first substrate stage 4) when it is present at the second station ST2.

The laser interferometers 2Px are capable of irradiating the reflecting surfaces 2Ka with the measurement lights that have measurement axes set in the X axial directions and measure the positions of the first and second substrate stages 4, 5 in the X axial directions. The laser interferometers 2Py are capable of irradiating the reflecting surfaces 2Ka with the measurement lights that have measurement axes set in the Y axial directions and measure the positions of the first and second substrate stages 4, 5 in the Y axial directions.

As shown in FIG. 3, the laser interferometers 2Pz are capable of irradiating the reflecting surfaces 2Kb with the measurement lights that have measurement axes set in the Z axial directions and measure the positions of the first and second substrate stages 4, 5 in the Z axial directions. The reflecting surfaces 2Kb are inclined at prescribed angles (e.g., 45°) so that they faces upward, and the measurement lights that are emitted from the laser interferometers 2Pz and radiated to the reflecting surfaces 2Kb are reflected by the reflecting surfaces 2Kb and radiated to reflecting surfaces 2Kc, which are provided to a prescribed support frame FC. Furthermore, the measurement lights that are reflected by the reflecting surfaces 2Kc pass through are reflected by the reflecting surfaces 2Kb of the substrate tables 4T, 5T and are received by the laser interferometers 2Pz. The laser interferometers 2Pz can measure the positional information of the first and second substrate stages 4, 5 in the Z axial directions using those received measurement lights. Furthermore, techniques related to a laser interferometer (Z interferometer) that is capable of measuring positional information of a substrate table (a substrate stage) in the Z axial directions are disclosed in, for example, Japanese Patent Application Publication No. 2000-323404A (corresponding U.S. Patent No. 6,674,510) and Published Japanese Translation No. 2001-513267 of the PCT International Publication (corresponding U.S. Patent No. 6,208,407).

In addition, the provision of a plurality of at least one of the laser interferometers 2Px and the laser interferometers 2Py and the irradiation of a plurality of at least one of the measurement lights that have measurement axes set in the X axial directions and the measurement lights that have measurement axes set in the Y axial directions enable the laser interferometer system 2 to measure the positional information of the first and second substrate stages 4, 5 in the θZ directions using that plurality of measurement lights. In addition, the provision of a plurality of the laser interferometers 2Pz and the irradiation of a plurality of measurement lights that have measurement axes set in the Z axial directions enable the laser interferometer system 2 to measure the positional information of the first and second substrate stages 4, 5 in the θX and θY directions using that plurality of measurement lights.

Furthermore, the control apparatus 10 controls the positions of the substrate tables 4T, 5T of the first and second substrate stages 4, 5 by driving the substrate stage drive apparatus PD based on the measurement results of the laser interferometer system 2, and thereby controls the position of the substrate P, which is held by the substrate holders 4H, 5H of the substrate tables 4T, 5T.

In the explanation below, the laser interferometers 2Px, 2Py, 2Pz are properly called the X interferometers 2Px, the Y interferometers 2Py, and the Z interferometers 2Pz, respectively.

The mark detection system 9, which acquires alignment information about the substrate P (positional information in the X axial, the Y axial, and the θZ directions) is disposed in the first station ST1. The mark detection system 9 acquires the alignment information using a detection light La to radiate the substrate P without going through the liquid LQ. The mark detection system 9 acquires alignment information by detecting alignment marks that are provided on the substrate P, which is held by the first substrate stage 4 or the second substrate stage 5. In addition, the mark detection system 9 is capable of detecting the fiducial marks 72, which are provided to the measurement areas 74,75.

In addition, the focus and level detection system 8, which detects surface information about the front surface of the substrate P (positional information about the surface in the Z axial, the θX, and the θY directions), which is held by the first substrate stage 4 or the second substrate stage 5, is disposed in the first station ST1. The focus and level detection system 8 comprises a light projecting system 8A that irradiates the front surface of the substrate P with a detection light Lf from a diagonal direction, and a light receiving system 8B that receives the detection light Lf that is radiated to the front surface of the substrate P and then reflected thereby. The focus and level detection system 8 detects positional information of the front surface of the substrate P, which is held by the first substrate stage 4 or the second substrate stage 5 that is disposed in the first station ST1.

In addition, the focus and level detection system detects inclination information (the rotational angle) of the substrate in the θX and the θY directions by measuring the positional information of the substrate in the Z axial directions at a plurality of measurement points. Furthermore, if, for example, the laser interferometers are capable of measuring the positional information of the substrate in the Z axial, the θX, and the θY directions, then the focus and level detection system does not need to be provided so that the positional information of the substrate can be measured in the Z axial directions during the exposure operation, and the position of the substrate in the Z axial, the θX, and the θY directions may be controlled using the measurement results of the laser interferometers at least during the exposure operation.

In addition, as shown in FIG. 2, a transport system H, which exchanges the substrate P, is provided in the vicinity of the first station ST1. The control apparatus 10 is capable of using the transport system H to perform the substrate exchange operation, i.e., unloading the exposure processed substrate P from the first substrate stage 4 (or the second substrate stage 5) that has moved to a substrate exchange position (loading position) RP in the first station ST1, and loading another substrate P that is to be exposure processed onto the first substrate stage 4 (or the second substrate stage 5).

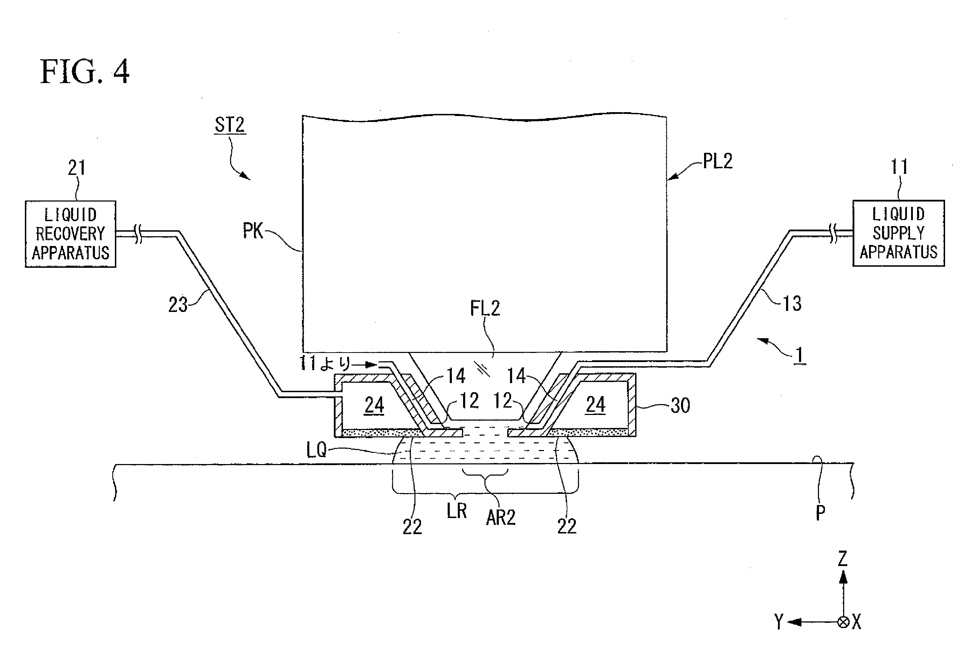

The immersion system 1 will now be explained, referencing FIG. 4. As discussed above, at the first station ST1, the exposure light EL is radiated on the substrate P without going through the liquid LQ, and, at the second station ST2, the exposure light EL is radiated on the substrate P through the liquid LQ. The immersion system 1 fills the optical path space of the exposure light EL on the light emergent side of the last optical element FL2 of the second projection system PL2 with the liquid LQ, and the substrate P at the second station ST2 is irradiated with the exposure light EL through the second projection system PL2 and the liquid LQ. In the present embodiment, the immersion system 1 fills the optical path space of the exposure light EL between the lower surface of the last optical element FL2 of the second projection system PL2 and the front surface of the substrate P on the substrate stage 4 or the substrate stage 5, which is disposed at the position that opposes the lower surface of the last optical element FL2, with the liquid LQ.

The immersion system 1 comprises: a nozzle member 30, which is provided in the vicinity of the optical path of the exposure light EL between the last optical element FL2 and the substrate P and comprises a supply port 12, which is for supplying the liquid LQ to the optical path, and a recovery port 22, which is for recovering the liquid LQ; a supply pipe 13; a liquid supply apparatus 11, which supplies the liquid LQ to the supply port 12 via a supply passageway 14, which is formed inside the nozzle member 30; and a liquid recovery apparatus 21, which recovers the liquid LQ recovered from the recovery port 22 of the nozzle member 30 via a recovery passageway 24, which is formed inside the nozzle member 30, and a recovery pipe 23.

The control apparatus 10 controls the operation of the immersion system 1. The control apparatus 10 controls the immersion system 1 so as to perform the liquid supply operation with the liquid supply apparatus 11 and the liquid recovery operation with the liquid recovery apparatus 21 in parallel, and thereby a liquid immersion region LR of the liquid LQ is formed on the substrate P so that the optical path space of the exposure light EL between the last optical element FL2 and the substrate P is filled with the liquid LQ. In addition, the exposure apparatus EX of the present embodiment employs a local liquid immersion system, wherein the liquid LQ, which fills the exposure light optical path between the final optical element FL2 and the substrate P, locally forms the immersion region LR of the liquid LQ, which is larger than a projection area AR2 and smaller than the substrate P, in part of the area on the substrate P that includes the projection area AR2 of the second projection optical system PL2. By filling the exposure light EL optical path space with the liquid LQ, the exposure apparatus EX can expose the substrate P with a substantially shortened exposure wavelength, improved resolution, and a substantially widened depth of focus.

Furthermore, the liquid immersion region LR can be formed not only on the substrate P, but also on an object that is disposed on the image plane side of the second projection system PL2 at a position that opposes (a position that is directly below) the last optical element FL2, e.g., on the upper surface of at least one of the first substrate stage 4 and the second substrate stage 5.

Furthermore, the immersion system may comprise a sealing member that is provided so that it surrounds the last optical element and is for filling a prescribed space, which includes the optical path on the light emergent side of the last optical element, with the liquid LQ, as disclosed in, for example, Japanese Patent Application Publication No. 2004-289126A (corresponding U.S. Patent No. 6,952,253) and Japanese Patent Application Publication No. 2004-289128 (corresponding U.S. Patent No. 7,075,616).

In the present embodiment, the control apparatus 10 exposes the substrate P that is held by the substrate stage 4 (5) at the first station ST1, and then performs an exposure (a multiple exposure) on the substrate P, which was exposed at the first station ST1, on the substrate stage 4 (5) at the second station ST2. Namely, at the second station ST2, the control apparatus 10 re-exposes the photosensitive layer of the substrate P that was exposed at the first station ST1 without subjecting the photosensitive layer to a developing process or the like. In addition, in parallel with at least part of the exposure of the substrate P that is held by the substrate stage 4 (5) at the first station ST1, the control apparatus 10 exposes the other substrate P that is held by the substrate stage 5 (4) at the second station ST2.

In addition, the control apparatus 10 acquires positional information (alignment information and surface information) about the substrate P using the detection systems (8, 9) at the first station ST1, and exposes the substrate P that is held by the substrate stage 4 (5) at the first station ST1 based on that acquired positional information. In addition, the control apparatus 10 exposes the substrate P that is held by the substrate stage 4 (5) at the second station ST2 based on the positional information that was acquired at the first station ST1. Namely, based on the positional information of the substrate P that is held by the substrate stage 4 (5) and that was acquired using the detection systems (8, 9) at the first station ST1, the control apparatus 10 exposes the substrate P that is held by the substrate stage 4 (5) at the first station ST1 and exposes the substrate P that is held by the substrate stage 4 (5) at the second station ST2.

In addition, in the present embodiment, the control apparatus 10 performs the exposure at the first station ST1 using first exposure conditions, and performs the exposure at the second station ST2 using second exposure conditions, which are different from the first exposure conditions. The first and second exposure conditions include at least one of: movement conditions of the substrate P; irradiation conditions of the exposure light EL with respect to the substrate P; and medium conditions of the medium that fills the optical path of the exposure light EL. Furthermore, not all of the first and second exposure conditions need to be different, and just some of those conditions may be different.

Naturally, just the pattern that is projected on the substrate P at the first station and the pattern that is projected on the substrate P at the second station may be different, and the first exposure conditions and the second exposure conditions may be the same.

As discussed above, with the present embodiment, a dry exposure is performed wherein the substrate P that is held by the substrate stage 4 (5) at the first station ST1 is irradiated with the exposure light EL without forming the liquid immersion region LR of the liquid LQ on the substrate P, and an immersion exposure is performed wherein the liquid immersion region LR of the liquid LQ is formed on the substrate P that is held by the substrate stage 4 (5) at the second station ST2, and the substrate P is irradiated with the exposure light EL through the liquid LQ. Namely, the medium that fills the exposure light EL optical path between the projection optical system PL1 and the substrate P during the exposure of the substrate P at the first station ST1 is a gas, and the medium that fills the exposure light EL optical path between the projection optical system PL2 and the substrate P during the exposure of the substrate P at the second station ST2 is the liquid LQ.

In addition, in the present embodiment, a so-called stationary exposure is performed wherein each shot region on the substrate P is irradiated with the exposure light EL at the first station ST1 in a state wherein the substrate P that is held by the substrate stage 4 (5) is substantially stationary. A so-called scanning exposure is performed at the second station ST2 wherein each shot region on the substrate P is irradiated with the exposure light EL while moving the substrate P that is held by the substrate stage 4 (5).

Alternatively, the scanning exposure may be performed at the first station and the stationary exposure may be performed at the second station. In addition, either the stationary exposure or the scanning exposure may be performed at both of the stations.

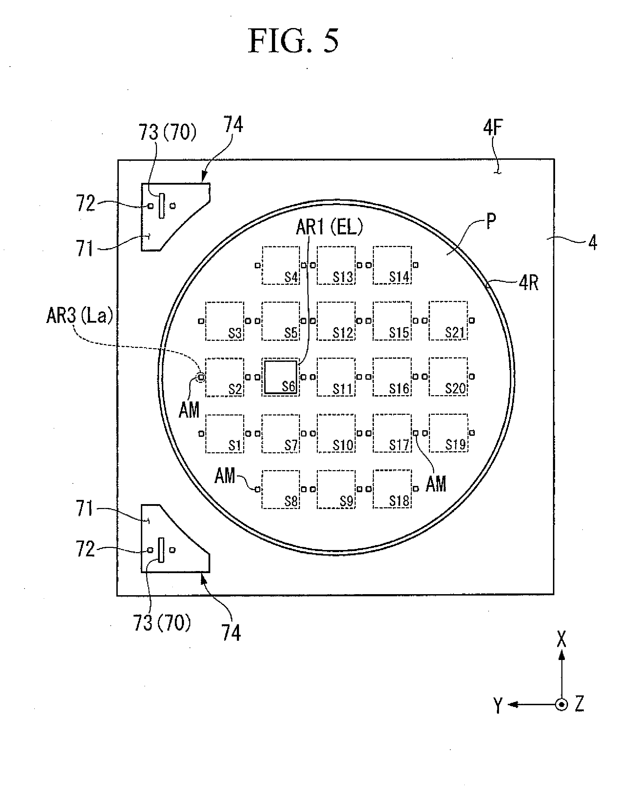

FIG. 5 is a plan view for explaining the operation wherein the substrate P that is held by the substrate stage 4 (5) at the Erst station ST1 is exposed. As shown in FIG. 5, a plurality of shot regions S1-S21, each of which is an area to be exposed, is set in a matrix on the substrate P. In addition, multiple alignment marks AM are provided on the substrate P of the present embodiment so that they correspond to the shot regions S1-S21. The mark detection system 9 detects the alignment marks AM on the substrate P without the intermediation of the liquid LQ.

At the first station ST1, the control apparatus 10 performs a full-field exposure of one shot region with the image of the pattern of the mask M that is held by the first mask stage 6 without forming the liquid immersion region on the substrate P that is held by the substrate stage 4 (5) and in a state wherein the mask M and the substrate P that is held by the substrate stage 4 (5) are substantially stationary, and then sequentially performs dry exposures of the multiple shot regions S1-S21 on the substrate P by using a step-and-repeat method to step the substrate P in order to expose each of the shot regions. A projection area AR1 of the first projection system PL1 of the first station ST1 has a shape and size that is in accordance with the shot regions S1-S21 and is set to a substantially square shape in FIG. 5.

In addition, in the present embodiment, it is possible to irradiate each of the shot regions on the substrate P with the exposure light EL in the first station ST1 and, substantially simultaneously therewith, to use the mark detection system 9 to radiate the detection light La to each of the alignment marks AM on the substrate P and to receive the reflected detection light La. The positional relationship between the irradiation area (the projection area) AR1 of the exposure light EL on the substrate P and an irradiation area AR3 of the detection light La that is irradiated by the mark detection system 9 is optimized so that the irradiations do not interfere with one another; furthermore, the mark detection system 9 can detect the alignment marks AM on the substrate P even during the exposure of the substrate P that is held by the substrate stage 4 (5) at the first station ST1.

Furthermore, although the detection system 9 of the present embodiment detects the alignment marks AM on the substrate P without using the projection optical system PL1, it may detect such with the detection light La that passes through at least some of the optical elements of the projection optical system PL1.

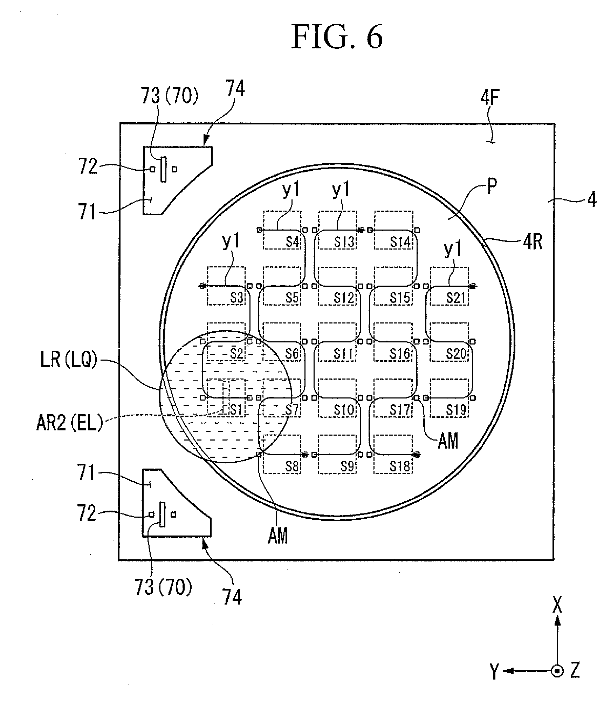

FIG. 6 is a plan view for explaining the operation wherein the substrate P that is held by the substrate stage 4 (5) at the second station ST2 is exposed. After the substrate P has been dry exposed at the first station ST1, the liquid immersion region LR of the liquid LQ is formed on the substrate P that is held by the substrate stage 4 (5) at the second station ST2, and the control apparatus 10 sequentially performs immersion exposures of the multiple shot regions S1-S21 on the substrate P. During the exposure of each of the shot regions S1-S21 on the substrate P at the second station ST2, the control apparatus 10 irradiates the substrate P with the exposure light EL through the liquid LQ of the liquid immersion region LR while moving the substrate P relative to the projection area AR2 of the second projection system PL2 and the liquid immersion region LR, which covers such, as shown by arrows y1 in FIG. 6 for example. The control apparatus 10 controls the operation of the substrate stage 4 (5) so that the projection areaAR2 (the exposure light EL) of the second projection optical system PL2 moves relative to the substrate P along the arrows y1, Namely, at the second station ST2, the control apparatus 10 exposes one af the shot regions with the image of the pattern formed in the mask M that is held by the second mask stage 7 while synchronously moving the mask M and the substrate P that is held by the substrate stage 4 (5) in prescribed scanning directions (herein, the Y axial directions), and then sequentially performs immersion exposures of the multiple shot regions S1-S21 on the substrate P by using a step-and-scan method to step the substrate P in order to expose each of the shot regions. The projection areaAR2 of the second projection system PL2 of the second station ST2 is formed so that it is smaller than the shot regions S1-S21, and is set to a rectangle (slit shape) in FIG. 6 such that its longitudinal directions are set to the X axial directions.

In addition, at the first and second stations ST1, ST2, the irradiation conditions of the exposure lights EL with respect to the substrate P are optimized in accordance with, for example, the masks M that are held by the first and second mask stages 6, 7 and the patterns that are to be formed on the substrate P.

Furthermore, FIG. 5 and FIG. 6 show the first substrate stage 4 and the substrate P that is held by the first substrate stage 4, but these figures apply similarly to the second substrate stage 5 and the substrate P that is held by the second substrate stage 5.

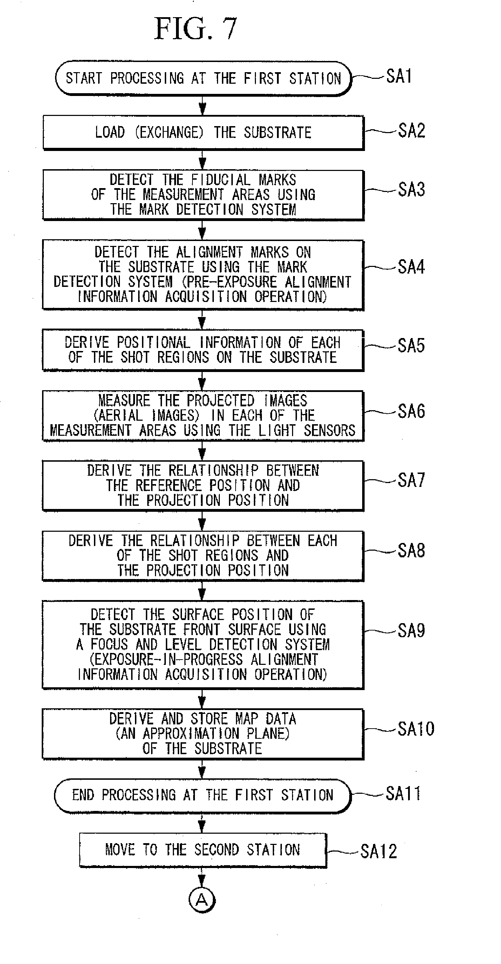

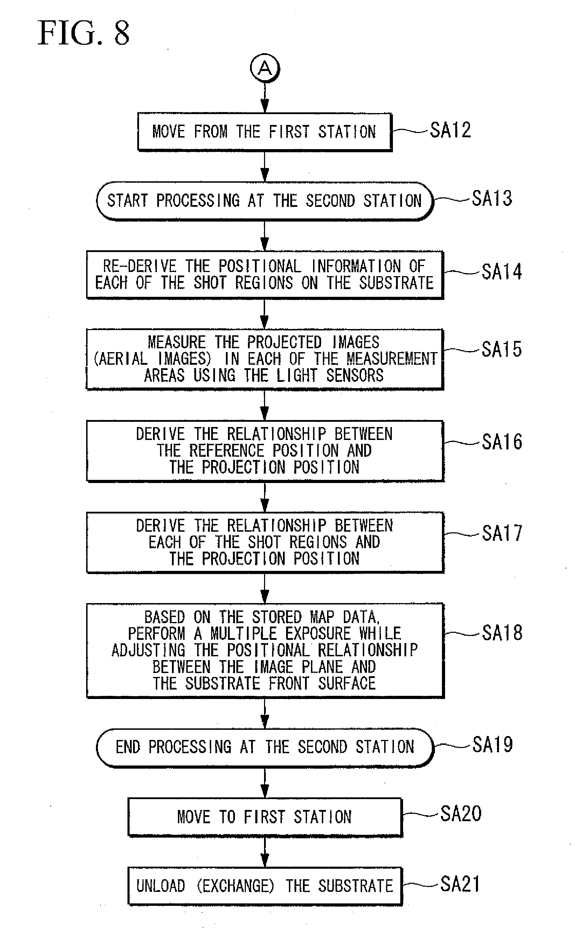

The following explains a method of exposing the substrate P using the exposure apparatus EX discussed above, referencing the flow chart diagrams in FIG. 7 and FIG. 8. The following principally explains the operation of performing a multiple exposure on the substrate P that is held by the first substrate stage 4.

If an instruction is issued to start processing at the first station ST1 (step SA1), then the control apparatus 10 disposes the first substrate stage 4 at the substrate exchange position RP at the first station ST1 and uses the transport system H to load the substrate P that is to undergo the exposure process onto the first substrate stage 4 (step SA2).

Furthermore, at the first station ST1, the control apparatus 10 starts the operation of acquiring positional information about the substrate P that is held by the first substrate stage 4. Moreover, the second substrate stage 5 is disposed at the second station ST2 and the exposure of the substrate P, for which the exposure process at the first station ST1 was completed, is started.

The control apparatus 10 uses the mark detection system 9 to acquire the alignment information of the substrate P that is held by the first substrate stage 4 at the first station ST1. At the first station ST1, the control apparatus 10 disposes each of the measurement areas 74 on the first substrate stage 4 at a detection area of the mark detection system 9 by moving the first substrate stage 4 in the X and Y directions. Furthermore, the control apparatus 10 uses the mark detection system 9 to detect each of the fiducial marks 72 that are provided to the measurement areas 74 on the first substrate stage 4 while measuring the positional information of the first substrate stage 4 in the X axial directions and the Y axial directions using the X interferometers 2Px and the Y interferometers 2Py (step SA3). The mark detection system 9 detects each of the fiducial marks 72 by using the detection light La to radiate each of the measurement areas 74 without going through the liquid LQ, and then receiving the light reflected therefrom.

Thereby, the control apparatus 10 can derive the positional information of the fiducial marks 72 on the measurement areas 74 in the X axial directions and the Y axial directions within the coordinate system that is defined by the laser interferometer system 2 (the X and Y interferometers 2Px, 2Py). In addition, if the mark detection system 9 has a detection reference position in the coordinate system that is defined by the laser interferometer system 2, then the control apparatus 10 can derive the positional relationship between the detection reference position of the mark detection system 9 and each of the fiducial marks 72.

In addition, at the first station ST1, the control apparatus 10 uses the mark detection system 9 to detect the alignment marks AM, which are provided on the substrate P so that they have prescribed positional relationships with multiple shot regions on the substrate P, while using the X interferometers 2Px and the Y interferometers 2Py to measure the positional information, in the X axial directions and the Y axial directions, of the first substrate stage 4 that holds the substrate P (step SA4). The mark detection system 9 uses the detection light La to radiate the substrate P without going through the liquid LQ and detects a prescribed number (for example, eight) of the alignment marks AM.

In the explanation below, the operation wherein the alignment information is acquired at the first station ST1 by using the mark detection system 9 to detect the alignment marks AM prior to the exposure of the substrate P is properly called the pre-exposure alignment information acquisition operation.

Thereby, the control apparatus 10 can derive the positional information of each of the alignment marks AM in the X axial directions and the Y axial directions within the coordinate system that is defined by the laser interferometer system 2 (the X and Y interferometers 2Px, 2Py).

Based on the positional information of each of the alignment marks AM on the substrate P derived in step SA4, the control apparatus 10 performs arithmetic processing to derive the information about the position of each of the multiple shot regions S1-S21 on the substrate P with respect to a prescribed reference position in the coordinate system that is defined by the laser interferometer system 2 (step SA5). When performing arithmetic processing in order to derive the positional information of each of the multiple shot regions S1-S21 on the substrate P, the so-called enhanced global alignment (EGA) method can be used, as disclosed in, for example, Japanese Patent Application Publication No. S61-44429A. Based on the output from the laser interferometer system 2, the control apparatus 10 knows where each of the shot regions S1-S21 on the substrate P is positioned with respect to the prescribed reference position.

While using the laser interferometer system 2 to measure the positional information of the first substrate stage 4, the control apparatus 10 uses the light sensors 70 that are provided to the measurement areas 74 to detect projected images (aerial images) of alignment marks that are provided to the mask M (step SA6).

Namely, the control apparatus 10 causes each of the measurement areas 74 to oppose the first projection system PL1 and illuminates the alignment marks that are provided to the mask M using the exposure light EL. Thereby, an aerial image of the alignment marks that are provided to the mask M is projected to each of the measurement areas 74 through the first projection system PL1, and the corresponding light sensor 70 that is provided to the measurement area 74 of the first substrate stage 4 can measure the aerial image of the alignment marks that are provided to the mask M without the intermediation of the liquid LQ. The control apparatus 10 can use the light sensors 70 (openings 73) that are provided to the measurement areas 74 to derive the positions of the aerial images (the projected images) in the X axial directions and the Y axial directions within the coordinate system that is defined by the laser interferometer system 2 (the X and Y interferometers 2Px, 2Py).

Because the pattern and the alignment marks on the mask M are formed with prescribed positional relationships and the positional relationships between the fiducial marks 72 and the openings 73 (light sensors) in the measurement areas 74 are also already known, the control apparatus 10 can derive, based on the measurement results from step SA6, the relationship between the prescribed reference position and a pattern projection position of the mask M in the coordinate system that is defined by the laser interferometer system 2 (step SA7).

Furthermore, the execution order of the detection of both the fiducial marks and the alignment marks with the mark detection system 9 as well as the measurement of the aerial images is not limited to the order discussed above that is shown in FIG. 7 and can be appropriately rearranged.

Based on the positional relationships between the prescribed reference position and the shot regions S1-S21 on the substrate P (the layout information of the shot regions S1-S21 with respect to the prescribed reference position) in the coordinate system that is defined by the laser interferometer system 2, which were derived in step SA5, and the relationship between the prescribed reference position and the pattern projection position of the mask M in the coordinate system defined by the laser interferometer system 2, which was derived in step SA7, the control apparatus 10 derives the relationship between each of the shot regions on the substrate P and the pattern projection position of the mask M in the coordinate system that is defined by the laser interferometer system 2 (step SA8).

Furthermore, in order to align each of the shot regions S1-S21 on the substrate P with the projection position of the image of the pattern of the mask M and sequentially expose each of the shot regions S1-S21 on the substrate P, the control apparatus 10 controls the position of the substrate P in the X axial directions, the Y axial directions, and the θZ directions by controlling the first drive system PD 1 based on the relationship, which was derived in step SA8, between the pattern projection position of the mask M and each of the shot regions S1-S21 on the substrate P (step SA9).

When the control apparatus 10 exposes each of the shot regions S1-S21 on the substrate P, it does so by using the image of the pattern of the mask M while detecting the surface information of the substrate P using the focus and level detection system 8 and adjusting the positional relationship (the positional relationship in the Z axial, the θX, and the θY directions) between the image plane of the first projection system PL1 and the front surface of the substrate P. Namely, the focus and level detection system 8 acquires the surface information about the substrate P that is held by the first substrate stage 4 in the first station ST1 during the exposure of the substrate P and, based on that information, uses feedback control to control the positional relationship between the image plane of the first projection system PL1 and the front surface of the substrate P. Furthermore, in the present embodiment, the positional relationship between the image plane of the first projection system PL1 and the front surface of the substrate P is adjusted by moving the substrate P; however, the image plane of the first projection system PL1 may be moved, or both the substrate P and the image plane of the first projection system PL1 may be moved.

Thus, in the present embodiment, the control apparatus 10 sequentially exposes the plurality of shot regions S1-S21 on the substrate P that is held by the first substrate stage 4 in the first station ST1 based on the alignment information about the substrate P that is held by the first substrate stage 4 that was acquired using the mark detection system 9 in the first station ST1 and the surface information of the substrate P that is held by the first substrate stage 4 that was acquired using the focus and level detection system 8 in the first station ST1.

In addition, the mark detection system 9 acquires the alignment information about the substrate P that is held by the first substrate stage 4 in the first station ST1 even during the exposure of the substrate P. As explained referencing FIG. 5, in the first station ST1, the radiation of the exposure light EL to each of the shot regions and the radiation of the detection light La to each of the alignment marks AM by the mark detection system 9 can be performed substantially simultaneously. In addition, the substrate P that is held by the first substrate stage 4 in the first station ST1 is irradiated with the exposure light EL in a state wherein it is substantially stationary, which makes it possible to smoothly detect the alignment marks AM using the mark detection system 9.

Thus, in the present embodiment, the control apparatus 10 additionally detects the alignment marks AM on the substrate P that is in the first station ST1 using the mark detection system 9 during the exposure of the substrate P. The mark detection system 9 radiates the detection light La to the substrate P without going through the liquid LQ, and additionally detects a prescribed number (for example, five) of the alignment marks AM.

In the explanation below, the operation wherein alignment information is acquired by using the mark detection system 9 to detect the alignment marks AM during the exposure of the substrate P in the first station ST1 is properly called the exposure-in-progress alignment information acquisition operation.

In the present embodiment, the eight alignment marks AM are detected by the pre-exposure alignment information acquisition operation, and the five alignment marks AM are detected by the exposure-in-progress alignment information acquisition operation; therefore, the detection of the thirteen alignment marks AM is completed after the exposure is performed at the first station ST1.

In addition, as discussed above, during the exposure of the substrate P that is held by the first substrate stage 4 in the first station ST1, the control apparatus 10 uses the focus and level detection system 8 to detect the surface information of the substrate P without the intermediation of the liquid LQ. While monitoring the outputs of the X and Y interferometers 2Px, Py, the control apparatus 10 uses the focus and level detection system 8 to detect the surface position information at a plurality of detection points in the plane (the XY plane) of the front surface of the substrate P while moving the first substrate stage 4 in the XY plane, which makes it possible to generate map data based on the positional information of the plurality of detection points on the front surface of the substrate P, and, based on that map data, to derive an approximation plane (an approximation surface) for each shot region on the front surface of the substrate P (step SA10).

In parallel with the operation of detecting the information of the front surface of the substrate P using the focus and level detection system 8, the control apparatus 10 uses the Z interferometers 2Pz to measure the positional information of the first substrate stage 4 in the Z axial directions. In addition, in the first station ST1 and with a prescribed timing (before starting and/or after ending the exposure of the substrate P), the control apparatus 10 uses the focus and level detection system 8 to detect the fiducial surfaces 71 that are provided to the measurement areas 74 on the first substrate stage 4 while using the Z interferometers 2Pz to measure the positional information of the first substrate stage 4 in the Z axial directions. Thereby, the control apparatus 10 can associate the detection results of the focus and level detection system 8 and the measurement results of the Z interferometers 2Pz.

Accordingly, the control apparatus 10 can derive the positional information about the front surface of the substrate P at a plurality of detection points in the coordinate system that is defined by the laser interferometer system 2 (the Z interferometers 2Pz), and, using the fiducial surfaces 71 as references, can derive the approximation plane of each shot region on the front surface of the substrate P. The control apparatus 10 stores the derived approximation planes of the substrate P.

After the exposure of the substrate P that is held by the first substrate stage 4 in the first station ST1 and the exposure of the substrate P that is held by the second substrate stage 5 in the second station ST2 are complete (step SA11), the control apparatus 10 moves the first substrate stage 4 to the second station ST2 and moves the second substrate stage 5 to the first station ST2 (step SA12).

After the control apparatus 10 moves the second substrate stage 5 that holds the substrate P, for which the exposure process was completed, from the second station ST2 to the first station ST1, it unloads the substrate P that underwent a multiple exposure from the second substrate stage 5 using the transport system H in the first station ST1. In addition, at the first station ST1, the transport system H loads the substrate P that is to be exposure processed onto the second substrate stage 5.

Moreover, the control apparatus 10 moves the first substrate stage 4 that holds the substrate P that was exposed in the first station ST1 to the second station ST2 and starts processing at the second station ST2 (step SA13).

Based on the alignment information that was acquired in the first station ST1, the control apparatus 10 re-derives the positional information of each of the shot regions S1-S21 on the substrate P (step SA13). Namely, the control apparatus 10 re-derives the positional information of each of the shot regions S 1-S21 on the substrate P based on the alignment information that was acquired prior to and during the exposure of the substrate P that was held by the first substrate stage 4 in the first station ST1.

The control apparatus 10 performs arithmetic processing using, for example, the EGA method so as to re-derive the positional information of each of the shot regions S 1-S21 on the substrate P using the positional information of the 13 alignment marks AM that were detected by the pre-exposure alignment information acquisition operation and the exposure-in-progress alignment information acquisition operation discussed above. Thereby, the control apparatus 10 can derive the positional information of each of the shot regions S1-S21 on the substrate P that is held by the first substrate stage 4 in the second station ST2 with respect to the prescribed reference position in the coordinate system that is defined by the laser interferometer system 2.

The control apparatus 10 uses the light sensors 70 that are provided to the measurement areas 74 to measure the projected images (the aerial images) of the alignment marks that are provided to the mask M while using the laser interferometer system 2 to measure the positional information of the first substrate stage 4 (step SA15).

The control apparatus 10 causes each of the measurement areas 74 to oppose the second projection system PL2 and irradiates the alignment marks that are provided to the mask M with the exposure light EL. Here, the immersion system 1 forms the liquid immersion region LR of the liquid LQ on the measurement area 74, and the optical path between the last optical element FL2 of the second projection system PL2 and the measurement area 74 is filled with the liquid LQ. The aerial image of the alignment marks that are provided to the mask M is projected to the measurement area 74 through the second projection system PL2 and the liquid LQ, and the light sensor 70 that is provided to the measurement area 74 of the first substrate stage 4 measures the aerial image of the alignment marks that are provided to the mask M through the liquid LQ. Thereby, the control apparatus 10 can derive the position of the aerial image (the projected image) in the X axial directions and the Y axial directions within the coordinate system that is defined by the laser interferometer system 2 (the X and Y interferometers 2Px, 2Py) using the light sensor 70 (opening 73) that is provided to the measurement area 74.

Because the pattern and the alignment marks on the mask M are formed with prescribed positional relationships and the positional relationships between the fiducial marks 72 and the openings 73 (the light sensors) in the measurement areas 74 are also already known, the control apparatus 10 can derive, based on the measurement results of step SA15, the relationship between the prescribed reference position and the pattern projection position of the mask M in the coordinate system that is defined by the laser interferometer system 2 (step SA16).

Furthermore, the re-derivation of the positional relationships of the shot regions discussed above may be performed prior to the start of processing at the second station ST2 or in parallel with the measurement of the aerial images.

The control apparatus 10 derives the relationship between each of the shot regions S1-S21 on the substrate P and the pattern projection position of the mask M in the coordinate system that is defined by the laser interferometer system 2 (step SA17) based on the positional relationships between the prescribed reference position and the shot regions S 1-S21 on the substrate P (the layout information of each of the shot regions with respect to the prescribed reference position) in the coordinate system that is defined by the laser interferometer system 2, which were derived in step SA14, and the relationship between the prescribed reference position and the pattern projection position of the mask M in the coordinate system that is defined by the laser interferometer system 2, which was derived in step SA16.

Here, during the measurement of the aerial images using the light sensors 70 in steps such as step SA15 discussed above, the position and the attitude of the substrate table 4T are controlled so that the plane of the image, which is formed through the second projection system PL2 and the liquid LQ, and the fiducial surfaces 71 substantially coincide. Thereby, the relationships among the measurement values of the Z interferometer 2Pz, the plane of the image that is formed through the second projection system PL2 and the liquid LQ, and the fiducial surfaces 71 are defined, and the control apparatus 10 can thereby determine the relationships among the approximation planes of the front surface of the substrate P that were derived in step SA10, the measurement values of the Z interferometers 2Pz, and the plane of the image that is formed through the second projection system PL2 and the liquid LQ.

Based on the approximation planes of the front surface of the substrate P that were derived in step SA10 and the measurement values of the Z interferometers 2Pz associated with the plane of the image formed through the second projection system PL2 and the liquid LQ, the control apparatus 10 adjusts the position of the front surface (the exposure surface) of the substrate P by controlling the second drive system PD2 and, based on the relationships between the pattern projection position of the mask M and the shot regions S1-S21 on the substrate P that were derived in step SA17, adjusts the position of the substrate P in the X axial directions, the Y axial directions, and the θZ directions by controlling the first drive system PD1; thereby, the control apparatus 10 sequentially performs immersion exposures of the plurality of shot regions S1-S21 on the substrate P (step SA18),

Thus, based on the alignment information that was acquired using the mark detection system 9 prior to and during the exposure of the substrate P that is held by the first substrate stage 4 in the first station ST1, the control apparatus 10 exposes the substrate P that is held by the first substrate stage 4 in the second station ST2. In addition, based on the surface information of the substrate P that was acquired using the focus and level detection system 8 during the exposure of the substrate P in the first station ST1, the control apparatus 10 exposes the substrate P that is held by the first substrate stage 4 in the second station ST2.

After the immersion exposure of the substrate P on the first substrate stage 4 in the second station ST2 is complete, the control apparatus 10 moves the first substrate stage 4 in the second station ST2 to the first station ST1 (step SA20). In parallel therewith, it moves the second substrate stage 5 that holds the substrate P, for which the exposure process was completed at the first station ST1, to the second station ST2. The control apparatus 10 uses the transport system H to unload the substrate P for which the exposure process is complete and that is held by the first substrate stage 4 that was moved to the first station ST1 (step SA21).

The control apparatus 10 repetitively performs the operation wherein multiple exposures are performed successively on a plurality of the substrates P by moving the first substrate stage 4 and the second substrate stage 5 back and forth between the first station ST1 and the second station ST2.

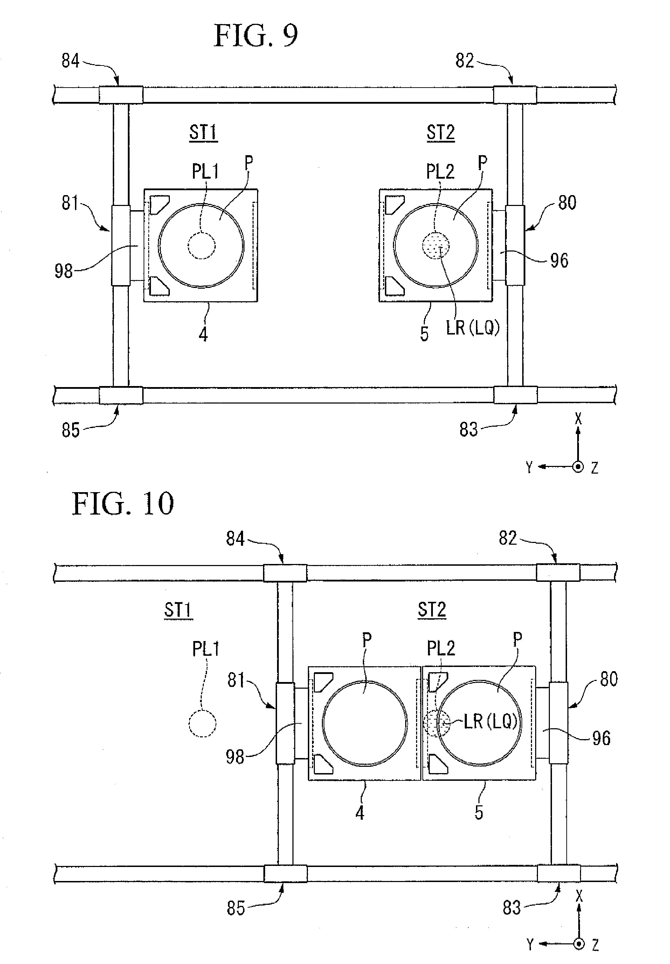

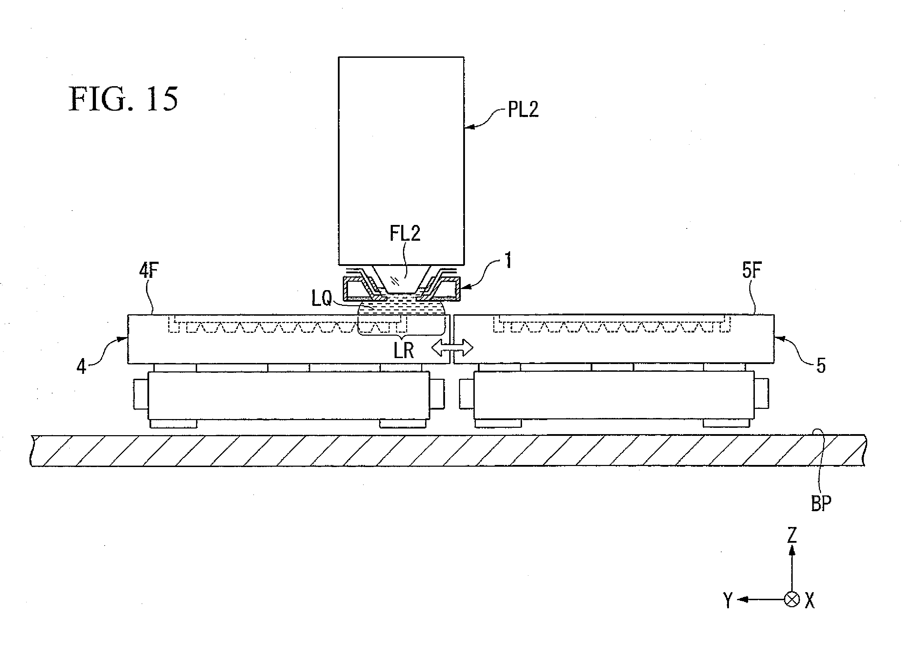

The operation of the first and second substrate stages 4, 5 during the multiple exposures of the substrates P will now be explained, referencing the plan views in FIG. 9 through FIG. 14 and the side view of FIG. 15.

As shown in FIG. 9, the first substrate stage 4 is disposed in the first station ST1 and the second substrate stage 5 is disposed in the second station ST2. The control apparatus 10 performs a dry exposure of the substrate P that is held by the first substrate stage 4 in the first station ST1 in parallel with at least part of the immersion exposure of the substrate P that is held by the second substrate stage 5 in the second station ST2.

After the exposure of the substrate P that is held by the first substrate stage 4 in the first station ST1 and the exposure of the substrate P that is held by the second substrate stage 5 in the second station ST2 are complete, the control apparatus 10, as shown in FIG. 10, brings the first substrate stage 4 proximate to the second substrate stage 5 in the state wherein the last optical element FL2 of the second projection system PL2 and the second substrate stage 5 are made to oppose one another and the liquid LQ is held therebetween. In the present embodiment, as shown in FIG. 10, an end part of the first substrate stage 4 on the -Y side that extends in the X axial directions and an end part of the second substrate stage 5 on the +Y side that extends in the X axial directions are brought into close proximity.

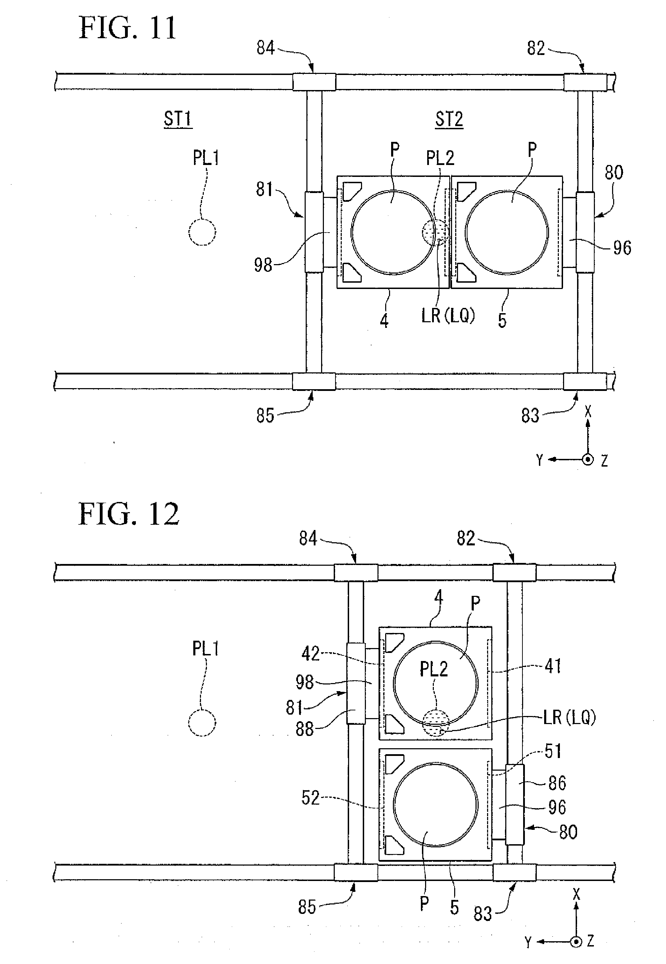

The control apparatus 10 can adjust the positional relationship between the first substrate stage 4 and the second substrate stage 5 using the stage drive apparatus PD and, as shown in FIG. 11 and FIG. 15, can move the liquid immersion region LR that is formed by the immersion system 1 back and forth between the upper surface 4F of the first substrate stage 4 and the upper surface 5F of the second substrate stage 5 by moving the first substrate stage 4 and the second substrate stage 5 together in the X and Y directions in a state wherein the upper surface 4F of the first substrate stage 4 and the upper surface 5F of the second substrate stage 5 are brought into close proximity or into contact with one another in a prescribed area that includes a position that is directly below the second projection system PL2. The control apparatus 10 moves the liquid immersion region LR that is formed on the second substrate stage 5 onto the first substrate stage 4. Furthermore, when moving the liquid immersion region from one of the substrate stages (e.g., the 5) to the other substrate stage (e.g., the 4), it is preferable to make the upper surface of the first substrate stage 4 and the upper surface of the second substrate stage 5 substantially flush with one another by adjusting the position of the upper surface of at least one of the substrate stages.

Next, in the state wherein the liquid LQ is held between the last optical element FL2 of the second projection system PL2 and the first substrate stage 4, the control apparatus 10 sets the first substrate stage 4 and the second substrate stage 5 so that they have the prescribed positional relationship in order to perform a switching operation while using the laser interferometer system 2 to measure the positional information of the first and second substrate stages 4, 5. In the present embodiment, as shown in FIG. 12, the control apparatus 10 disposes the second substrate stage 5 on the -X side of the first substrate stage 4. The liquid immersion region LR continues to be formed on the first substrate stage 4.

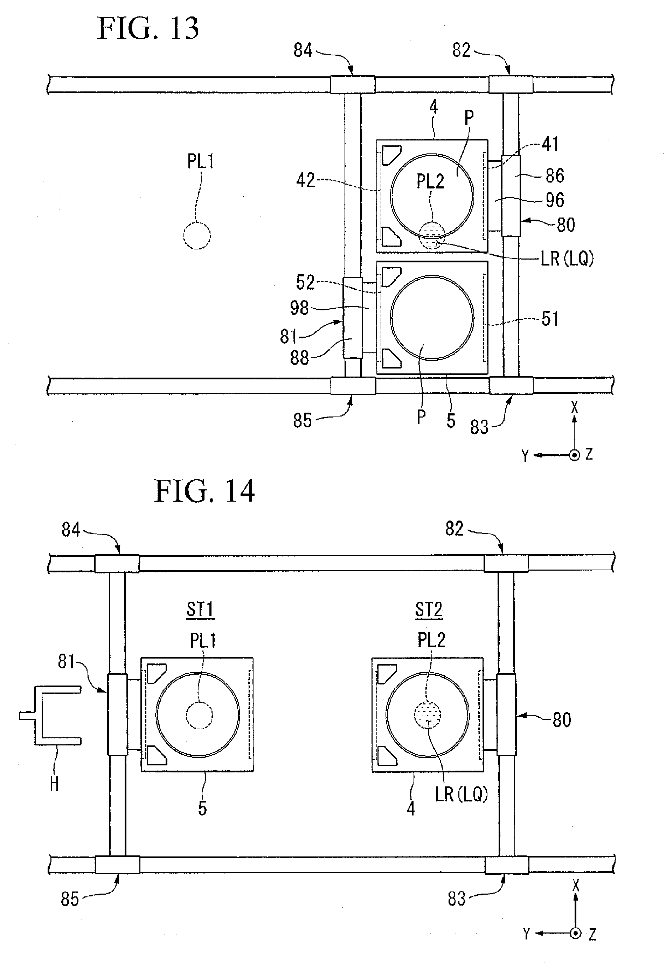

Next, the connection between the joint member 96 of the slider 86 and the third joint member 51 of the second substrate stage 5 and the connection between the joint member 98 of the slider 88 and the second joint member 42 of the first substrate stage 4 are released; in addition, as shown in FIG. 13, the second substrate stage 5 is connected to the slider 88 of the linear motor 81 via the fourth j oint member 52 and the joint member 98, and the first substrate stage 4 is connected to the slider 86 of the linear motor 80 via the first joint member 41 and the joint member 96.

Thus, the slider 86 of the linear motor 80 that was connected to the second substrate stage 5 is connected to the first substrate stage 4 and the slider 88 of the linear motor 81 that was connected to the first substrate stage 4 is connected to the second substrate stage 5, thereby completing the switching operation.

Furthermore, the control apparatus 10 controls the substrate stage drive apparatus PD so as to move the second substrate stage 5 to the first area SP1 of the first station ST1 and dispose the first substrate stage 4 at a prescribed position in the second area SP2 of the second station ST2 as shown in FIG. 14. Furthermore, based on the alignment information that was acquired in the first station ST1, the control apparatus 10 performs an immersion exposure of the substrate P that is held by the first substrate stage 4 in the second station ST2. In the first station ST1, the transport system H unloads the substrate P, which has undergone a multiple exposure, from the second substrate stage 5.

As explained above, the exposure apparatus EX is provided with the first station ST1, wherein the substrate P is exposed, and the second station ST2, wherein the substrate P that was exposed at the first station ST1 is exposed, which reduces the operations of exchanging masks, modifying exposure conditions such as illumination conditions, and the like for each exposure, even during the performance of a multiple exposure; thus, it is possible to prevent a reduction in the operating ratio and the throughput of the exposure apparatus EX and thereby to perform multiple exposures of the substrates P efficiently.

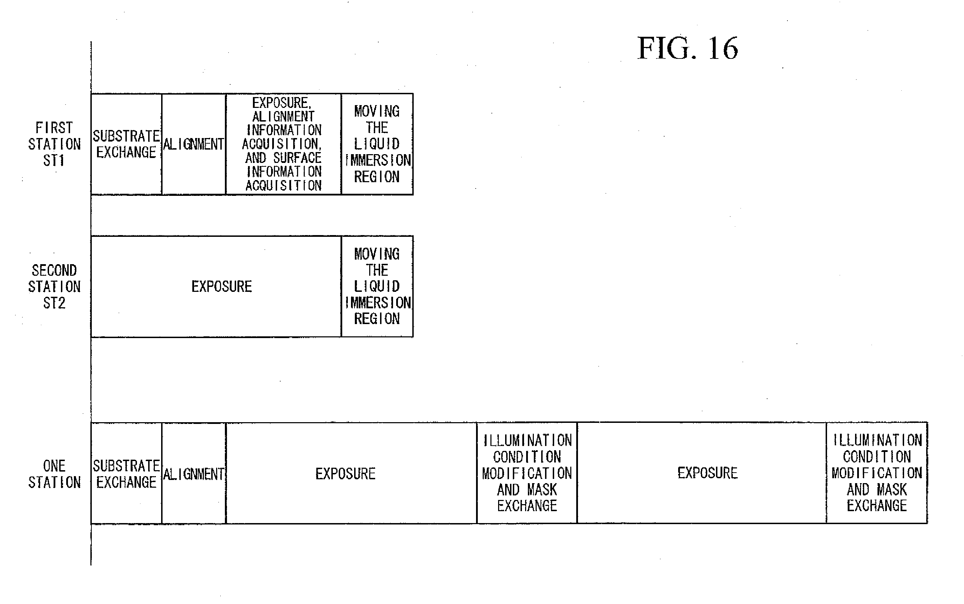

Part (A) of FIG. 16 is a schematic view of a sequence that is followed by the first and second stations ST1, ST2 of the exposure apparatus EX according to the present embodiment, and part (B) of FIG. 16 is a schematic view of a sequence wherein an exposure apparatus, which comprises just one station that exposes a substrate, double exposes a substrate. As shown in part (A) of FIG. 16, performing the exposure operations at a plurality of stations ST1, ST2 in parallel makes it possible to prevent a reduction in the operating ratio and the throughput of the exposure apparatus EX. Moreover, if a substrate is double exposed at one station as shown in part (B) of FIG. 16, then the exchanging of the masks or the modification of the illumination conditions takes time, which leads to a reduction in the operating ratio of the exposure apparatus EX. In addition, in a case wherein a substrate is double exposed at one station as shown in part (B) of FIG. 16, if a liquid immersion method is adopted in one of the exposures, then the liquid immersion method must also be adopted in the other exposure. This is because, even in a case wherein it is sufficient that the other exposure is performed at a low resolution, it is necessary to match the numerical aperture of the projection optical system PL to the exposure that requires high resolution. Accordingly, if the liquid immersion method is adopted in one of the exposures, then, even if it is sufficient to perform the other exposure in a gas (a so-called dry exposure) wherein operation can be performed at a higher speed, the liquid immersion method must be adopted wherein there is a possibility that much more operation time will be needed compared with the other exposure. In the present embodiment, the exposure apparatus EX is provided with a plurality of stations, each of which exposes one of the substrates P, which makes it possible to perform multiple exposures on the substrates P efficiently.

In addition, in the present embodiment, at the first station ST1, the alignment information is acquired using the mark detection system 9 and the surface information is acquired using the focus and level detection system 8, and, based on that acquired information, an exposure is performed at the first station ST1 and an exposure is performed at the second station ST2. Thus, the present embodiment reduces the need to perform the operation that acquires the positional information of each of the substrates P, thereby preventing a reduction in throughput. In addition, multiple processes are performed in parallel at the first station ST1 such as additionally acquiring alignment information using the mark detection system 9 during the exposure of the substrate P, and acquiring surface information using the focus and level detection system 8, which also make it possible to prevent a reduction in throughput.

In addition, in the present embodiment, the alignment information is additionally acquired during the exposure of the substrate P at the first station ST1 and, to supplement that additional alignment information, the substrate P is aligned at the second station ST2; therefore, the process of exposing the substrate P at the second station ST2 can be performed more accurately. This is effective in cases wherein the accuracy (the resolution) of the exposure process at the second station ST2 is higher than the accuracy (the resolution) of the exposure process at the first station ST1 (the case wherein the substrate P is exposed at the second station with the image of a pattern that is finer than that of the exposure that is performed at the first station).

In addition, multiple exposures generally expose the substrate P with different patterns, but it is not necessarily the case that each of those exposures is performed with the same exposure accuracy. In a case wherein a multiple exposure is performed on the substrate P, there is a possibility that, for example, the resolutions of the first and second exposures may be different, or that the optical performances of the projection systems that are used in the first and second exposures may be different. For example, there is a possibility that the numerical aperture of the projection system that is used in the first exposure may be smaller than that of the projection system that is used in the second exposure. In a case where there is only one station (projection system) at which the substrate P is exposed, there is a possibility that a situation will arise wherein an exposure that would allow a comparatively low resolution is performed using, for example, a projection system with a large numerical aperture. In the present embodiment, it is possible to provide the first and second projection systems PL1, PL2, each of which has an optical performance (numerical aperture) that is in accordance with its target resolution, to the first and second stations ST1, ST2, respectively, which makes it possible to prevent an increase in apparatus costs and to expose the substrates P efficiently.

In the embodiments discussed above, the resolution that is permitted in the exposure at the first station ST1 is comparatively low, and therefore the first projection system PL1 with a comparatively small numerical aperture and a comparatively large projection area AR1 is used to expose each of the multiple shot regions S1-S21 on the substrate P efficiently, i.e., in a short time period, and with an increased depth of focus using a step-and-repeat method. Moreover, the resolution that is required for the exposure at the second station ST2 is high, and therefore the second projection system PL2 with a comparatively large numerical aperture is used to substantially shorten the exposure wavelength and to improve the resolution using the liquid immersion method, and to expose each of the multiple shot regions S 1-S21 on the substrate P with high precision and a substantially increased depth of focus using the step-and-scan method.

In addition, in the embodiments discussed above, the exposures of the substrates P at the first station ST1 and the second station ST2 are performed in parallel; however, there is a strong possibility that the exposure time at the first station ST1 that uses the first projection system PL1 with a small numerical aperture will be shorter than the exposure time at the second station ST2 that uses the second projection system PL2 with a large numerical aperture, and there is consequently a possibility that idle time will arise in the processing at the first station ST1. In the present embodiment, the positional information (the alignment information and the surface information) of the substrate P is acquired at the first station ST1, which makes it possible to utilize that idle time effectively.

In addition, in the embodiments discussed above, the exposure at the second station ST2 is performed at a higher resolution than that of the exposure that is performed at the first station ST1; however, the positional information of the alignment marks AM that were detected by the pre-exposure alignment information acquisition operation and the positional information of the alignment marks AM that were detected by the exposure-in-progress alignment information acquisition operation are each used when the positional information of the shot regions S1-S21 on the substrate P is derived in order to perform an exposure at the second station ST2. Namely, the positional information of the shot regions S1-S21 on the substrate P needed to perform an exposure at the second station ST2 is derived based on the positional information of multiple alignment marks AM that are greater in number than the multiple alignment marks AM that are detected in order to derive the positional information of the shot regions S 1-S21 on the substrate P needed to perform an exposure at the first station ST1. Namely, in order to support high precision exposure at the second station ST2, the positional information of the shot regions S1-S21 is derived with high precision using the positional information of the greater number of the alignment marks AM. Deriving the positional information of each of the shot regions S1-S21 on the substrate P in order to perform exposure at the second station ST2 with higher precision makes it possible to perform a high precision exposure process at the second station ST2.

Furthermore, in the embodiments discussed above, the alignment marks AM on the substrate P are additionally detected during the exposure of the substrate P at the first station ST1; however, the alignment marks AM on the substrate P may be additionally detected using the mark detection system 9 after the substrate P is exposed at the first station ST1 and before that substrate P is moved to the second station ST2.

Furthermore, if it is possible to align the substrate P at the second station ST2 with the desired precision using just the positional information of each of the alignment marks that were detected by the pre-exposure alignment information acquisition operation, then the exposure-in-progress alignment information acquisition operation may be omitted.

In addition, the operation wherein the focus and level detection system 8 is used to acquire the surface position information of the substrate P may be performed without using the mark detection system 9 to detect the alignment marks on the substrate P prior to the exposure of the substrate P at the first station ST1.

Furthermore, in the embodiments discussed above, the liquid immersion region LR is moved to and from the upper surface 4F of the first substrate stage 4 and the upper surface 5F of the second substrate stage 5 by moving the first substrate stage 4 and the second substrate stage 5 together in a state wherein the first substrate stage 4 and the second substrate stage 5 are brought into close proximity or contact with one another, as was explained referencing FIG. 15; however, the liquid immersion region may be moved to and from the first substrate stage 4 and the second substrate stage 5 using a cap member that is capable of holding the liquid LQ between itself and the last optical element of the projection system, as disclosed in, for example, Japanese Patent Application Publication No. 2004-289128A (corresponding U.S. Patent No. 7,075,616).

Furthermore, in the embodiments discussed above, a dry exposure is performed at the first station ST1 wherein the exposure light EL is radiated on the substrate P without going through the liquid LQ, and an immersion exposure is performed at the second station ST2 wherein the exposure light EL is radiated on the substrate P through the liquid LQ; however, dry exposures may be performed at both the first station ST1 and the second station ST2. In addition, immersion exposures may be performed at both the first station ST1 and the second station ST2. If immersion exposures are performed at both the first station ST1 and the second station ST2, then, for example, water (pure water) may be used as the liquid in the first station ST1 and glycerol (glycerin), which has a refractive index that is higher than that of water (e.g., a refractive index of approximately 1.6-1.8 with respect to the exposure light), or the like may be used as the liquid in the second station ST2. In addition, a liquid other than water or glycerol may be used as the liquid LQ. For example, if the light source of the exposure light EL is an F₂ laser, the light of which does not transmit through water, then it is acceptable to use a fluorine based fluid that is capable of transmitting F₂ laser light, e.g., perfluorinated polyether (PFPE) or fluorine based oil, as the liquid LQ.

Alternatively, examples of liquids that can be used as the liquid LQ include: a prescribed liquid that has an O-H bond or a C-H bond such as isopropanol, which has a refractive index of approximately 1.50, or glycerol (glycerin), which has a refractive index of approximately 1.61; a prescribed liquid (organic solvent) such as hexane, heptane, or decane; and a prescribed liquid such as decalin or bicyclohexyl. Alternatively, two or more arbitrary types of these prescribed liquids may be mixed together, or an abovementioned prescribed liquid may be added to (mixed with) pure water. Alternatively, the liquid LQ may be a liquid wherein a base, such as H⁺, Cs⁺, K ⁺, Cl⁻, SO₄²⁻, PO₄²⁻, or an acid is added to (mixed with) pure water. Furthermore, the liquid LQ may be a liquid wherein fine particles of aluminum oxide or the like are added to (mixed with) pure water. Such liquids LQ can transmit ArF excimer laser light. In addition, it is preferable that the liquid LQ is a liquid that has a small light absorption coefficient, low temperature dependency, and that is stable with respect to the photosensitive material (a protective film such as a topcoat film; an antireflection film; or the like) coated on the projection optical system PL and/or the front surface of the substrate P.

In addition, last optical elements LS1, LS2 can be formed from, for example, quartz (silica). Alternatively, they may be formed from a monocrystalline fluorine compound material such as calcium fluoride (fluorite), barium fluoride, strontium fluoride, lithium fluoride, sodium fluoride, and BaLiF₃. Furthermore, the final optical elements may be formed from lutetium aluminum garnet (LuAG). In addition, they may be formed from a monocrystalline fluorine compound material such as sodium fluoride and.

In addition, at least one of the optical elements of the projection optical system may be formed from a material that has a refractive index that is higher than that of quartz and/or fluorite (e.g., 1.6 or greater). For example, it is possible to use sapphire, germanium dioxide, or the like as disclosed in PCT International Publication WO 2005/059617, or potassium chloride (which has a refractive index of approximately 1.75) or the like as disclosed in PCT International Publication WO 2005/059618.

Furthermore, the projection system of the second station ST2 in the embodiments discussed above fills the liquid in the space of the optical path on the image plane side of the tip optical element, but it is also possible to employ a projection system that fills the liquid in the space of the optical path on the object plane side of the tip optical element as well, as disclosed in PCT International Publication WO2004/019128 (corresponding U.S. Patent Application No. 2005/0248856).

Furthermore, the substrates P in the abovementioned embodiments are not limited to semiconductor wafers for fabricating semiconductor devices; for example, glass substrates for display devices, ceramic wafers for thin film magnetic heads, or the original plates of masks and reticles (synthetic quartz, silicon wafers) that are used by an exposure apparatus can be employed as the substrates P. The shape of each of the substrates is not limited to a circle, and it may be another shape, e.g., a rectangle.

In addition, the exposure apparatus EX can also be adapted to an exposure apparatus that uses a projection system (e.g., a dioptric projection system, which does not include a reflecting element, that has a 1/8 reduction magnification) to expose each of the substrates P with the full field of a reduced image of a first pattern in a state wherein the first pattern and the substrate P are substantially stationary. In this case, the exposure apparatus EX can also be adapted to a stitching type full field exposure apparatus that subsequently further uses that projection system to expose the substrate P with the full field of a reduced image of a second pattern, in a state wherein the second pattern and the substrate P are substantially stationary, so that the second pattern partially overlaps the first. In addition, the stitching type exposure apparatus can also be adapted to a step-and-stitch type exposure apparatus that transfers at least two patterns onto the substrate P so that they are partially superposed, and sequentially steps the substrate P.

Furthermore, in the embodiments discussed above, the exposure at the first station ST1 is performed with the step-and-repeat method, and the exposure at the second station ST2 is performed with the step-and-scan method; however, the exposure at the second station ST2 may be performed with the step-and-repeat method and the exposure at the first station ST1 may be performed with the step-and-scan method. In addition, the exposures at both of the first and second stations ST1, ST2 may be performed with the step-and-repeat method or with the step-and-scan method.

In addition, the embodiments discussed above explained an exemplary case wherein there are two stations at which the substrates P can be exposed; however, there may be an arbitrary plurality of three or more stations at which the substrates P can be exposed. In addition, the number of movable substrate stages that hold the substrates P is not limited to two, and a plurality of three or more can be provided.

In addition to the substrate stages, a measurement stage may be provided whereon various photoelectric sensors and a fiducial member, wherein fiducial marks are formed, are mounted.

In addition, in the exposure apparatus of the abovementioned embodiments, each of the masks is disposed above (on the +Z side) each of the projection optical systems (multiple projection modules) and each of the substrates is disposed therebelow (on the -Z side); however, the projection optical systems (multiple projection modules) may be provided so that they are flipped upside down vertically (in a Z axial direction), and each of the substrates may be disposed above (on the +Z side) of each of the projection optical systems, and each of the masks may be disposed therebelow (on the -Z side), as disclosed in, for example, PCT International Publication WO2004/090956 (corresponding U.S. Patent Application No. 2006/0023188A1).

Furthermore, in the abovementioned embodiments, positional information about the mask stages and the substrate stages is measured using the interferometer system, but the present invention is not limited thereto and, for example, an encoder system may be used that detects a scale (diffraction grating) that is provided to the upper surface of each of the substrate stages. In this case, it is preferable to adopt a hybrid system that is provided with both an interferometer system and an encoder system, and to use the measurement results of the interferometer system to calibrate the measurement results of the encoder system. In addition, the position of each of the substrate stages may be controlled by switching between the interferometer system and the encoder system, or by using both.

In addition, the abovementioned embodiments explained an exemplary case wherein the exposure apparatus is provided with the projection optical systems, but the present invention can be adapted to an exposure apparatus and an exposure method that do not use the projection optical systems. Even if a projection optical system is not used, exposure light is radiated onto the substrate through optical members, such as a mask or a lens, and an immersion region is formed in a prescribed space between the substrate and such optical members.

The type of exposure apparatus EX is not limited to a semiconductor device fabrication exposure apparatus that exposes the pattern of a semiconductor device on the substrate P, but can also be widely adapted to an exposure apparatus that is used for fabricating, for example, liquid crystal devices or displays, and an exposure apparatus that is used for fabricating thin film magnetic heads, image capturing devices (CCDs), micromachines, MEMS, DNA chips, or reticles and masks.

Furthermore, in the embodiments discussed above, light transmitting type masks are used wherein prescribed shielding patterns (or phase patterns or dimming patterns) are formed on light transmitting substrates; however, instead of such masks, it is also possible to use electronic masks wherein transmittance patterns, reflected patterns, or light emitting patterns are formed based on electronic data of the patterns to be exposed, as disclosed in, for example, U.S. Patent No. 6,778,257; here, electronic masks, which are also called variable forming masks, include, for example, digital micromirror devices (DMDs), which are one type of non light emitting image display devices (spatial light modulators).

In addition, by forming interference fringes on the substrates P as disclosed in, for example, PCT International Publication WO2001/035168, the present invention can also be adapted to an exposure apparatus (a lithographic system) that exposes the substrates P with line-and-space patterns.

Furthermore, the present invention can also be adapted to an exposure apparatus that combines, through a projection optical system, the patterns of two masks on a substrate, and double exposes, substantially simultaneously, a single shot region on that substrate with a single scanning exposure, as disclosed in, for example, Published Japanese Translation No. 2004-519850 of the PCT International Publication (corresponding U.S. Patent No. 6,611,316).

As far as is permitted, the disclosures in all of the Publications and U.S. Patents related to exposure apparatuses and the like cited in the above respective embodiments and modified examples, are incorporated herein by reference.

As described above, the exposure apparatus EX of the abovementioned embodiments is manufactured by assembling various subsystems, including each constituent element, so that prescribed mechanical, electrical, and optical accuracies are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The process of assembling the exposure apparatus from the various subsystems includes, for example, the mechanical interconnection of the various subsystems, the wiring and connection of electrical circuits, and the piping and connection of the atmospheric pressure circuit. Naturally, prior to performing the process of assembling the exposure apparatus from these various subsystems, there are also the processes of assembling each individual subsystem. When the process of assembling the exposure apparatus from the various subsystems is complete, a comprehensive adjustment is performed to ensure the various accuracies of the exposure apparatus as a whole. Furthermore, it is preferable to manufacture the exposure apparatus in a clean room wherein, for example, the temperature and the cleanliness level are controlled.

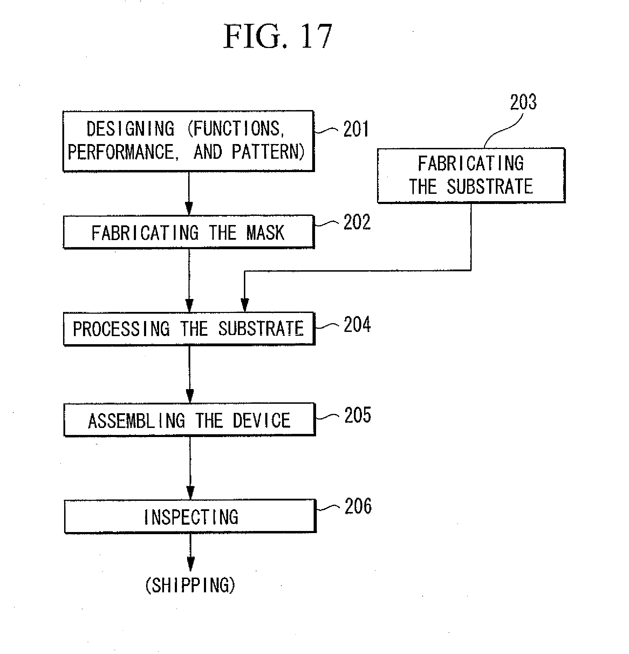

As shown in FIG. 17, a micro-device, such as a semiconductor device, is manufactured by, for example: a step 201 that designs the functions and performance of the micro-device; a step 202 that fabricates a mask (reticle) based on this designing step; a step 203 that fabricates a substrate, which is the base material of the device; a step 204 that includes substrate treatment processes, such as the process of exposing the pattern of the mask onto the substrate by using the exposure apparatus EX of the embodiments discussed above, a process that develops the exposed substrate, and a process that heats (cures) and etches the developed substrate; a device assembling step 205 (comprising a dicing process, a bonding process, and a packaging process); and an inspecting step 206.

## Claims

1. An exposure apparatus for performing a multiple exposure, comprising:
a first station;
a second station;
a first movable member that holds a substrate and that is capable of moving between the first station and the second station;
a second movable member that holds a substrate and that is capable of moving between the first station and the second station; and
a first detection system that is disposed in the first station;
wherein,
alignment information about the substrate that is held by the first movable member is acquired using the first detection system in the first station;
the substrate that is held by the first movable member is exposed in the first station based on the alignment information;
the substrate that is held by the second movable member is exposed in the second station in parallel with at least part of the exposure of the substrate that is held by the first movable member in the first station;
the first movable member is moved from the first station to the second station after the exposure of the substrate that is held by the first movable member at the first station and the exposure of the substrate that is held by the second movable member at the second station are complete; and
the substrate that is held by the first movable member is exposed at the second station based on the alignment information.

2. An exposure apparatus according to Claim 1, further comprising:
a second detection system that is disposed in the first station;
wherein,
the substrate that is held by the first movable member is exposed at the first station and the second station based on surface information of the substrate that is held by the first movable member and that was acquired using the second detection system in the first station.

3. An exposure apparatus according to Claim 2, wherein
the second detection system acquires the surface information during the exposure of the substrate that is held by the first movable member at the first station.

4. An exposure apparatus according to any one of Claims 1 to 3, wherein
the first detection system acquires the alignment information of the substrate that is held by the first movable member using the first detection system even during the exposure of the substrate that is held by the first movable member at the first station; and
the substrate that is held by the first movable member at the second station is exposed based on the alignment information that was acquired during the exposure.

5. An exposure apparatus according to any one of Claims 1 to 4, wherein
an exposure condition with respect to the substrate that is held by the first movable member in the first station differs from that in the second station.

6. An exposure apparatus according to Claim 5, wherein
the exposure condition includes at least one of a movement condition of the substrate, an irradiation condition of an exposure beam with respect to the substrate, and a medium condition of a medium that fills a path of the exposure beam.

7. An exposure apparatus according to any one of Claims 1 to 6, wherein
the exposure beam is radiated through a liquid to the substrate that is held by the first movable member at the first station, at the second station, or at both.

8. An exposure apparatus according to Claim 7, wherein
the exposure beam is radiated to the substrate that is held by the first movable member at the first station without going through the liquid; and
the exposure beam is radiated through the liquid to the substrate that is held by the first movable member at the second station.

9. An exposure apparatus according to Claim 8, further comprising:
an optical member that is disposed in the second station and has an emergent surface, which emits the exposure beam, that contacts the liquid;
wherein,
at least one of the first movable member and the second movable member is caused to oppose the optical member, and the optical path space on the emergent surface side of the optical member continues to be filled with the liquid after the exposure of the substrate that is held by the first movable member in the first station and the exposure of the substrate that is held by the second movable member in the second station are complete and prior to the start of the exposure of the substrate that is held by the first movable member in the second station.

10. An exposure apparatus according to any one of Claims 1 to 9, wherein
in order to acquire the alignment information, the first detection system radiates a detection light to the substrate that is held by the first movable member without going through the liquid.

11. An exposure apparatus according to any one of Claims 1 to 10, wherein
the alignment information is acquired by using the first detection system to detect an alignment mark on the substrate that is held by the first movable member.

12. An exposure apparatus according to any one of Claims 1 to 11, wherein
the second movable member is moved from the second station to the first station after the exposure of the substrate that is held by the first movable member in the first station and the exposure of the substrate that is held by the second movable member in the second station are complete; and
the substrate that has been subject to a multiple exposure is unloaded from the second movable member in the first station.

13. A device fabricating method, comprising:
performing a multiple exposure of a substrate using an exposure apparatus according to any one of Claims 1 to 12; and
developing the substrate that has undergone the multiple exposure.

14. An exposing method for performing a multiple exposure, comprising:
acquiring alignment information about a substrate that is held by a first movable member in a first station;
exposing the substrate that is held by the first movable member in the first station based on the alignment information;
exposing a substrate that is held by a second movable member in a second station in parallel with at least part of the exposure of the substrate that is held by the first movable member in the first station;
moving the first movable member from the first station to the second station after the exposure of the substrate that is held by the first movable member at the first station and the exposure of the substrate that is held by the second movable member at the second station are complete; and
exposing the substrate that is held by the first movable member at the second station based on the alignment information.

15. An exposing method according to Claim 14, wherein
surface information about a front surface of the substrate that is held by the first movable member is acquired during the exposure of the substrate that is held by the first movable member in the first station; and
the substrate that is held by the first movable member is exposed in the first station and the second station based on the surface information.

16. An exposing method according to Claim 14 or Claim 15, wherein
an exposure beam is radiated to the substrate that is held by the first movable member in the first station without going through the liquid; and
an exposure beam is radiated through the liquid to the substrate that is held by the first movable member in the second station.

17. An exposing method according to any one of Claims 14 to 16, wherein
in the first station, the exposure beam is radiated to the substrate that is held by the first movable member, which is substantially stationary; and
in the second station, the exposure beam is radiated to the substrate that is held by the first movable member while moving the substrate that is held by the first movable member.

18. A device fabricating method, comprising:
performing a multiple exposure on a substrate using an exposing method according to any one of Claims 14 to 17; and
developing the substrate that has undergone the multiple exposure.
